# EUROPEAN PATENT APPLICATION

(11) **EP 4 094 940 A1**
(43) Date of publication of application: **30.11.2022**
(21) Application number: 21744248.2
(22) Date of filing: 20.01.2021
(51) Int. Cl.: B32B 27/28, C08F 290/06, C08G 61/02, C08G 65/48, C08G 73/00, C08L 53/02, C08J 5/24, H05K 1/03

(54) **RESIN COMPOSITION, RESIN SHEET, PREPREG, AND PRINTED WIRING BOARD**

(30) Priority: 24.01.2020 JP 2020010181; 28.01.2020 JP 2020011977; 25.02.2020 JP 2020029923; 25.02.2020 JP 2020029924
(71) Applicant: MITSUBISHI GAS CHEMICAL COMPANY, INC., Chiyoda-ku Tokyo 100-8324 (JP); MGC Electrotechno Co., Ltd., Tokyo 100-8324 (JP)
(72) Inventor: HIRANO Shunsuke, Yonezawa-shi Yamagata 992-1128 (JP); KATO Yoshihiro, Shirakawa-gun Fukushima 961-8031 (JP); ITO Meguru, Shirakawa-gun Fukushima 961-8031 (JP); NOBUKUNI Takeshi, Yonezawa-shi Yamagata 992-1128 (JP); SUGIMOTO Noriaki, Yonezawa-shi Yamagata 992-1128 (JP); KUBO Takashi, Shirakawa-gun Fukushima 961-8031 (JP); KOGA Shouta, Shirakawa-gun Fukushima 961-8031 (JP); UENO Yoshitaka, Shirakawa-gun Fukushima 961-8031 (JP)
(74) Representative: TBK
(86) International application number: PCT/JP2021/001889
(87) International publication number: WO 2021/149733

(57) **Abstract**

[Problem] Provided is a resin composition, resin sheet, prepreg and printed wiring board capable of obtaining excellent low permittivity, low dielectric loss tangent, flexibility and peel strength.

[Solution Means] A resin composition containing (A) a maleimide compound exhibiting a relative permittivity of lower than 2.7, (B) a polyphenylene ether compound represented by general formula (1) below and having a number-average molecular weight of 1000 to 7000, and (C) a block copolymer with a styrene skeleton. In general formula (1), X represents an aryl group, -(Y-O)n₂- represents a polyphenylene ether portion, R₁, R₂ and R₃ each independently represent a hydrogen atom or an alkyl, alkenyl or alkynyl group, n₂ represents an integer of 1 to 100, n₁ represents an integer of 1 to 6 and n₃ represents an integer of 1 to 4.

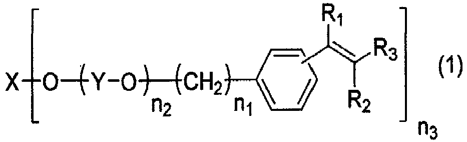

## Description

### Technical Field

The present invention relates to a resin composition, and to a resin sheet, prepreg and printed wiring board using the resin composition.

### Background Art

Printed wiring boards widely used in electronic devices, communication devices and personal computers have recently been undergoing development for higher densification, higher integration and smaller thickness. At the same time, requirements are increasing for the insulating layers in printed wiring boards to have lower permittivity, lower dielectric loss tangent and thinner film thicknesses, and a large variety of resin compositions for such insulating layers have been studied in the prior art. For example, Patent Literature 1 describes a resin composition containing a maleimide compound (A), a cyanic acid ester compound (F), a polyphenylene ether compound (B) with a specific structure and a number-average molecular weight of 1000 to 7000, and a block copolymer (C) having a styrene skeleton. The resin composition is able to simultaneously exhibit low permittivity, a low dielectric loss tangent and low thermal expansion, and can yield uniform cured products.

### Citation List

### Patent Literature

Patent Literature 1: International Patent Publication No. WO2019/230945

### Summary of Invention

### Technical Problem

In a conventional printed wiring board, however, a prepreg having glass fibers impregnated with a resin is commonly used as the insulating layer. The resin composition described in Patent Literature 1 is also applied in a prepreg. Since a prepreg contains glass fibers, it can exhibit constant strength, but the thickness cannot be made smaller than the thickness of the glass fibers. Such prepregs have therefore had insufficient suitability for recent requirements for smaller thicknesses. Because the permittivities and dielectric loss tangents of glass fibers and resins in a prepreg differ, the properties of the insulating layer are non-uniform, and since the permittivity and dielectric loss tangent of the glass fibers are greater than those of the resin, it has been difficult to achieve further lowering of the permittivity or lowering of the dielectric loss tangent. In addition, the increasingly higher frequencies of electrical signals used in recent years has led to greater loss of high frequency signals when using insulating layers that have unstable permittivity, due to skin effects, and this has made it difficult to obtain adequate properties.

Constructing insulating layers of resins without using glass fibers allows thinner film formation, lower permittivity, lower dielectric loss tangent and lower high frequency signal loss to be achieved, but the flexibility obtained with conventional resin compositions has been less than satisfactory and molding defects have resulted, while it has also been impossible to obtain adequate peel strength.

The present invention has been devised in light of these problems, and its first object is to provide a resin composition that has excellent low permittivity, low dielectric loss tangent, flexibility and peel strength, that is able to form thin films, and that can reduce high frequency signal loss, as well as a resin sheet and printed wiring board using the resin composition.

The second object of the invention is to provide a prepreg with excellent moldability, low permittivity, low dielectric loss tangent and peel strength.

### Solution to Problem

The present inventors have completed this invention upon finding that the problems described above can be solved by a resin composition having a combination of (A) a maleimide compound having an aromatic ring in the main backbone and exhibiting a relative permittivity of lower than 2.7 at 10 GHz when cured alone, (B) a specific polyphenylene ether compound and (C) a block copolymer having a styrene skeleton.

The present invention is as follows.
[1] A resin composition containing (A) a maleimide compound having an aromatic ring in the main backbone and exhibiting a relative permittivity of lower than 2.7 at 10 GHz when cured alone, (B) a polyphenylene ether compound represented by general formula (1) below and having a number-average molecular weight of 1000 to 7000, and (C) a block copolymer having a styrene skeleton. 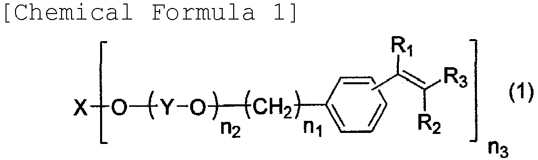 (In general formula (1), X represents an aryl group, -(Y-O)n₂- represents a polyphenylene ether portion, R₁, R₂ and R₃ each independently represent a hydrogen atom or an alkyl, alkenyl or alkynyl group, n₂ represents an integer of 1 to 100, n₁ represents an integer of 1 to 6 and n₃ represents an integer of 1 to 4.)
[2] The resin composition according to [1] above, wherein the maleimide compound (A) is at least one selected from the group consisting of compounds represented by general formula (6) and compounds represented by general formula (22) . 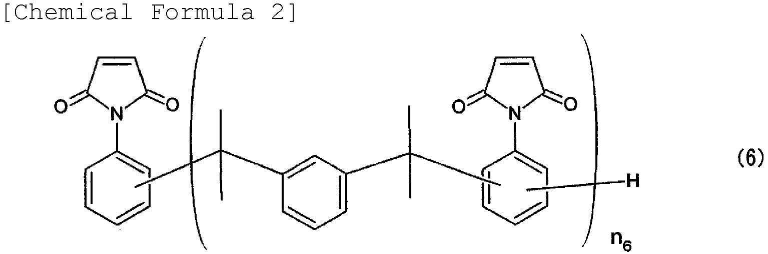 (In general formula (6), n₆ represents an integer of 1 or greater.) 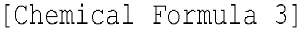 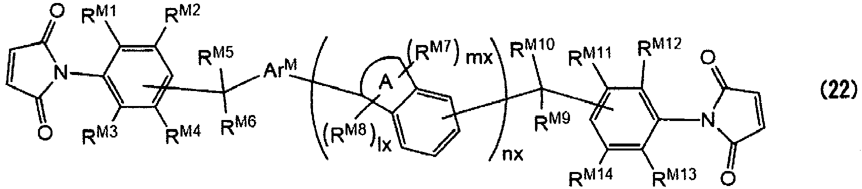 (In general formula (22), R^{M1}, R^{M2}, R^{M3} and R^{M4} each independently represent a hydrogen atom or an organic group. R^{M5} and R^{M6} each independently represent a hydrogen atom or an alkyl group. Ar^{M} represents a divalent aromatic group. A is an alicyclic group with a 4- to 6-membered ring. R^{M7} and R^{M8} each independently represent an alkyl group. mₓ is 1 or 2 and lₓ is 0 or 1. R^{M9} and R^{M10} each independently represent a hydrogen atom or an alkyl group. R^{M11}, R^{M12}, R^{M13} and R^{M14} each independently represent a hydrogen atom or an organic group. nₓ represents an integer of 0 to 20.)
[3] The resin composition according to [1] above, wherein the block copolymer having a styrene skeleton (C) contains at least one selected from the group consisting of styrene-butadiene block copolymers, styrene-isoprene block copolymers, styrene-hydrogenated butadiene block copolymers, styrene-hydrogenated isoprene copolymers and styrene-hydrogenated (isoprene/butadiene) copolymers.
[4] The resin composition according to [1] above, which further contains a maleimide compound (D) other than the maleimide compound (A).
[5] The resin composition according to [4] above, wherein the maleimide compound (D) contains at least one selected from the group consisting of the following general formulas (2), (3), (4) and (5) . 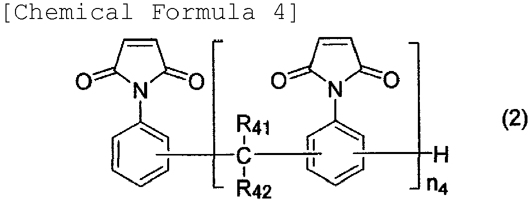 (In general formula (2), R₄₁ and R₄₂ each independently represent a hydrogen atom or methyl group, and n₄ represents an integer of 1 or greater.) 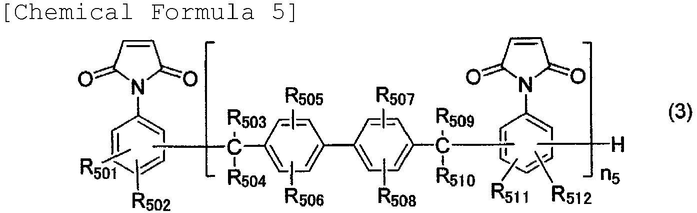 (In general formula (3), R₅₀₁, R₅₀₂, R₅₀₃, R₅₀₄, R₅₀₅, R₅₀₆, R₅₀₇, R₅₀₈, R₅₀₉, R₅₁₀, R₅₁₁ and R₅₁₂ each independently represent a hydrogen atom or an alkyl group of 1 to 8 carbon atoms or a phenyl group, and n₅ represents an integer of 1 to 10.) 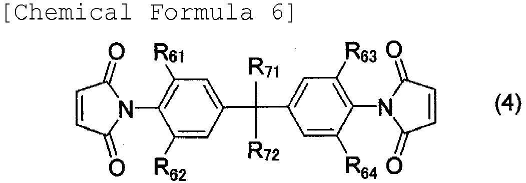 (In general formula (4), R₆₁, R₆₂, R₆₃ and R₆₄ each independently represent a hydrogen atom or a methyl or ethyl group, and R₇₁ and R₇₂ each independently a hydrogen atom or a methyl group.) 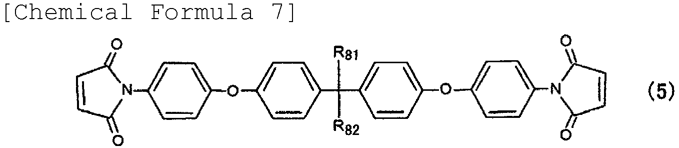 (In general formula (5), R₈₁ and R₈₂ each independently represent a hydrogen atom or a methyl or ethyl group.)
[6] The resin composition according to [1] above, which further contains a flame retardant (E).
[7] The resin composition according to [1] above, which further contains a cyanic acid ester compound (F).
[8] A resin sheet that includes a support and a layer formed from a resin composition according to [1] above disposed on the surface of the support.
[9] A prepreg that includes a base material and a resin composition according to [1] above impregnated into or coated onto the base material.
[10] A printed wiring board that includes an insulating layer and a conductive layer disposed on the surface of the insulating layer, wherein the insulating layer includes a layer formed from a resin composition according to [1] above. Advantageous Effects of Invention

With the resin composition, resin sheet and printed wiring board of the invention, it is possible to obtain excellent low permittivity, low dielectric loss tangent, flexibility and peel strength, and to form thin films, and reduce high frequency signal loss. With the prepreg, it is possible to obtain excellent moldability, low permittivity, low dielectric loss tangent and peel strength. The present invention therefore has very high industrial utility.

### Description of Embodiments

An embodiment for carrying out the invention (hereunder referred to as "the embodiment") will now be described in detail, with the understanding that the invention is not limited to the embodiment and may incorporate various modifications within the scope of its gist.

### Resin composition]

The resin composition of the embodiment contains (A) a maleimide compound having an aromatic ring in the main backbone and exhibiting a relative permittivity of lower than 2.7 at 10 GHz when cured alone, (B) a polyphenylene ether compound represented by general formula (1) below and having a number-average molecular weight of 1000 to 7000, and (C) a block copolymer having a styrene skeleton. 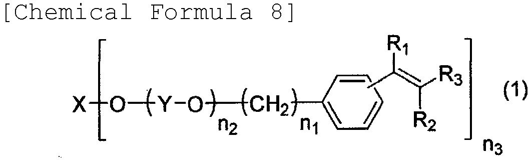 (In general formula (1), X represents an aryl group, -(Y-O)n₂- represents a polyphenylene ether portion, R₁, R₂ and R₃ each independently represent a hydrogen atom or an alkyl, alkenyl or alkynyl group, n₂ represents an integer of 1 to 100, n₁ represents an integer of 1 to 6 and n₃ represents an integer of 1 to 4.)

### Maleimide compound (A)]

The maleimide compound (A) of the embodiment is a compound having at least one maleimide group in the molecule, and it exhibits a relative permittivity of lower than 2.7 at 10 GHz when cured alone. The resin composition of the embodiment contains a maleimide compound (A), and thereby exhibits excellent low permittivity, low dielectric loss tangent and peel strength. The maleimide compound (A) preferably includes, for example, at least one selected from the group consisting of compounds represented by general formula (6) and compounds represented by general formula (22) . 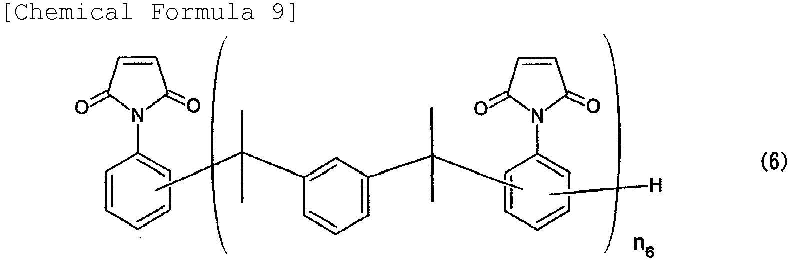 In general formula (6), n₆ represents an integer of 1 or greater. Compound (A) represented by general formula (6) may also include two or more compounds with different n₆. 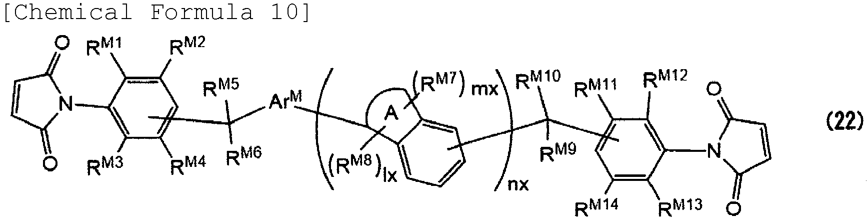 (In general formula (22), R^{M1}, R^{M2}, R^{M3} and R^{M4} each independently represent a hydrogen atom or an organic group. R^{M5} and R^{M6} each independently represent a hydrogen atom or an alkyl group. Ar^{M} represents a divalent aromatic group. A is an alicyclic group with a 4- to 6-membered ring. R^{M7} and R^{M8} each independently represent an alkyl group. mₓ is 1 or 2 and lₓ is 0 or 1. R^{M9} and R^{M10} each independently represent a hydrogen atom or an alkyl group. R^{M11}, R^{M12}, R^{M13} and R^{M14} each independently represent a hydrogen atom or an organic group. nₓ represents an integer of 0 to 20.)

Compound (A) represented by general formula (22) may also include two or more compounds with different nₓ.

R^{M1}, R^{M2}, R^{M3} and R^{M4} in general formula (22) each independently represent a hydrogen atom or an organic group. The organic group here is preferably an alkyl group, more preferably an alkyl group of 1 to 12 carbon atoms, even more preferably an alkyl group of 1 to 6 carbon atoms, yet more preferably a methyl, ethyl, propyl or butyl group, and most preferably a methyl group. Preferably, R^{M1} and R^{M3} are each independently an alkyl group, and preferably R^{M2} and R^{M4} are each a hydrogen atom.

R^{M5} and R^{M6} are each independently a hydrogen atom or alkyl group, and preferably an alkyl group. The alkyl group here is preferably an alkyl group of 1 to 12 carbon atoms, even more preferably an alkyl group of 1 to 6 carbon atoms, yet more preferably a methyl, ethyl, propyl or butyl group, and most preferably a methyl group.

Ar^{M} represents a divalent aromatic group, preferably a phenylene, naphthalenediyl, phenanthrenediyl or anthracenediyl group, more preferably a phenylene group and even more preferably an m-phenylene group. Ar^{M} may have a substituent, where the substituent is preferably an alkyl group, more preferably an alkyl group of 1 to 12 carbon atoms, even more preferably an alkyl group of 1 to 6 carbon atoms, yet more preferably a methyl, ethyl, propyl or butyl group, and most preferably a methyl group. Ar^{M} is most preferably unsubstituted.

A is an alicyclic group with a 4- to 6-membered ring, and more preferably a 5-membered alicyclic group (preferably an indane ring group with a benzene ring). R^{M7} and R^{M8} are each independently an alkyl group, preferably an alkyl group of 1 to 6 carbon atoms, more preferably an alkyl group of 1 to 3 carbon atoms and most preferably a methyl group. mₓ is 1 or 2 and preferably 2. lₓ is 0 or 1 and preferably 1.

R^{M9} and R^{M10} are each independently a hydrogen atom or alkyl group, and preferably an alkyl group. The alkyl group here is preferably an alkyl group of 1 to 12 carbon atoms, even more preferably an alkyl group of 1 to 6 carbon atoms, yet more preferably a methyl, ethyl, propyl or butyl group, and most preferably a methyl group.

R^{M11}, R^{M12}, R^{M13} and R^{M14} each independently represent a hydrogen atom or an organic group. The organic group here is preferably an alkyl group, more preferably an alkyl group of 1 to 12 carbon atoms, even more preferably an alkyl group of 1 to 6 carbon atoms, yet more preferably a methyl, ethyl, propyl or butyl group, and most preferably a methyl group. Preferably, R^{M12} and R^{M13} are each independently an alkyl group, and preferably R^{M11} and R^{M14} are each a hydrogen atom.

nₓ represents an integer of 0 to 20. nₓ may be an integer of 10 or smaller. The resin composition of the embodiment is a maleimide compound (A) represented by general formula (22), and when it includes a compound where nₓ is 0, it will include at least one compound where nₓ is not 0 in addition to a compound where nₓ is 0, but it may also include 2 or more compounds where nₓ is not 0. When it does not include a compound where nₓ is 0, it may include only one compound where nₓ is a different value, or it may include two or more compounds with different values. When it includes 2 or more, the average n for nₓ (average number of repeat units) in the maleimide compound (A) represented by general formula (22) for the resin composition is preferably 0.95 or greater, more preferably 0.98 or greater, even more preferably 1.0 or greater, and yet more preferably 1.1 or greater, and preferably 10.0 or lower, more preferably 8.0 or lower, even more preferably 7.0 or lower and yet more preferably 6.0 or lower, for a low melting point (low softening point), a low melt viscosity and excellent handling properties. The same applies for formula (26) and formula (27) below.

The compound represented by general formula (22) is preferably a compound represented by general formula (26) below. 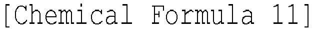 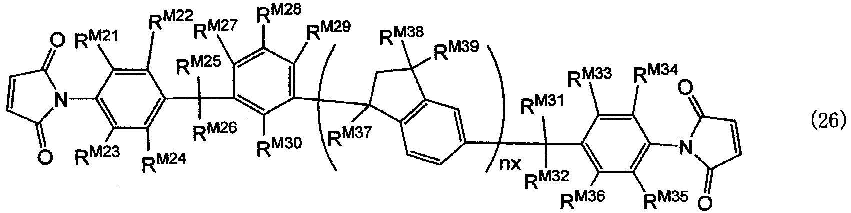 (In general formula (26), R^{M21}, R^{M22}, R^{M23} and R^{M24} each independently represent a hydrogen atom or an organic group. R^{M25} and R^{M26} each independently represent a hydrogen atom or an alkyl group. R^{M27}, R^{M28}, R^{M29} and R^{M30} each independently represent a hydrogen atom or an organic group. R^{M31} and R^{M32} each independently represent a hydrogen atom or an alkyl group. R^{M33}, R^{M34}, R^{M35} and R^{M36} each independently represent a hydrogen atom or an organic group. R^{M37}, R^{M38} and R^{M39} each independently represent a hydrogen atom or an alkyl group. nₓ represents an integer of 0 to 20.)

R^{M21}, R^{M22}, R^{M23} and R^{M24} in general formula (26) each independently represent a hydrogen atom or an organic group. The organic group here is preferably an alkyl group, more preferably an alkyl group of 1 to 12 carbon atoms, even more preferably an alkyl group of 1 to 6 carbon atoms, yet more preferably a methyl, ethyl, propyl or butyl group, and most preferably a methyl group. Preferably, R^{M21} and R^{M23} are each independently an alkyl group, and preferably R^{M22} and R^{M24} are each a hydrogen atom.

R^{M25} and R^{M26} are each independently a hydrogen atom or alkyl group, and preferably an alkyl group. The alkyl group here is preferably an alkyl group of 1 to 12 carbon atoms, even more preferably an alkyl group of 1 to 6 carbon atoms, yet more preferably a methyl, ethyl, propyl or butyl group, and most preferably a methyl group.

R^{M27}, R^{M28}, R^{M29} and R^{M30} each independently represent a hydrogen atom or an organic group, and preferably a hydrogen atom. The organic group here is preferably an alkyl group, more preferably an alkyl group of 1 to 12 carbon atoms, even more preferably an alkyl group of 1 to 6 carbon atoms, yet more preferably a methyl, ethyl, propyl or butyl group, and most preferably a methyl group.

R^{M31} and R^{M32} are each independently a hydrogen atom or alkyl group, and preferably an alkyl group. The alkyl group here is preferably an alkyl group of 1 to 12 carbon atoms, even more preferably an alkyl group of 1 to 6 carbon atoms, yet more preferably a methyl, ethyl, propyl or butyl group, and most preferably a methyl group.

R^{M33}, R^{M34}, R^{M35} and R^{M36} each independently represent a hydrogen atom or an organic group. The organic group here is preferably an alkyl group, more preferably an alkyl group of 1 to 12 carbon atoms, even more preferably an alkyl group of 1 to 6 carbon atoms, yet more preferably a methyl, ethyl, propyl or butyl group, and most preferably a methyl group.

R^{M33} and R^{M36} are preferably hydrogen atoms and R^{M34} and R^{M35} are preferably alkyl groups.

R^{M37}, R^{M38} and R^{M39} are each independently a hydrogen atom or alkyl group, and preferably an alkyl group. The alkyl group here is preferably an alkyl group of 1 to 12 carbon atoms, even more preferably an alkyl group of 1 to 6 carbon atoms, yet more preferably a methyl, ethyl, propyl or butyl group, and most preferably a methyl group. nₓ represents an integer of 0 to 20. nₓ may be an integer of 10 or smaller.

The compound represented by general formula (26) is preferably a compound represented by general formula (27) below. 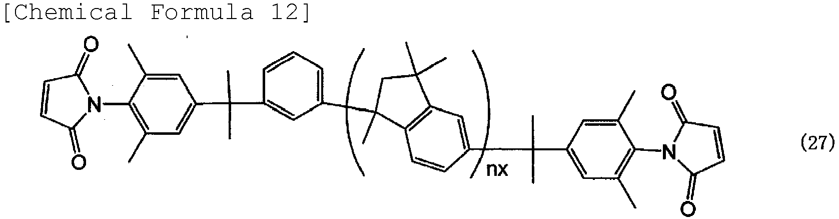 (In general formula (27), nₓ represents an integer of 0 to 20.)

The molecular weight of compound (A) represented by general formula (22) is preferably 500 or greater, more preferably 600 or greater and even more preferably 700 or greater. At above the lower limit, the dielectric characteristics (low permittivity) and low water absorption will tend to be improved. The molecular weight of compound (A) represented by general formula (22) is preferably 10,000 or lower, more preferably 9000 or lower, even more preferably 7000 or lower, yet more preferably 5000 or lower and most preferably 4000 or lower. At below the upper limit, the heat resistance and handleability will tend to be further improved.

Compound (A) represented by general formula (22) used for the embodiment preferably yields a cured product with high heat resistance. The cured product of compound (A) represented by general formula (22) used for the embodiment preferably has a glass transition temperature of 180°C or higher, more preferably 200°C or higher and even more preferably 230°C or higher, as measured by JIS C6481 dynamic viscoelasticity. At above the lower limit, the cured product that is obtained will have more excellent heat resistance. The upper limit for the glass transition temperature is 400°C or lower in practice.

Compound (A) represented by general formula (22) used for the embodiment preferably yields a cured product with excellent dielectric characteristics. For example, the cured compound (A) represented by general formula (22) used for the embodiment preferably has a relative permittivity of lower than 2.7 at 10 GHz, and more preferably 2.6 or lower, as measured by the cavity resonance perturbation method. The lower limit for the permittivity is 2.0 or greater, for example, in practice. The cured compound (A) represented by general formula (22) used for the embodiment has a dissipation factor (Df) at 10 GHz of preferably 0.01 or lower and more preferably 0.007 or lower, as measured by the cavity resonance perturbation method. The lower limit for the dissipation factor is 0.0001 or greater, for example, in practice.

The content of compound (A) represented by general formula (22) in the resin composition of the embodiment is preferably 1 mass% or greater and more preferably 5 mass% or greater, with respect to the total solid resin content. At above the lower limit, the heat resistance will tend to be further improved. The upper limit for the content of compound (A) represented by general formula (22) is preferably 90 mass% or lower, more preferably 60 mass% or lower, even more preferably 40 mass% or lower and most preferably 30 mass% or lower, of the solid resin content in the resin composition. At below the upper limit, the low water absorption will tend to be further improved. The resin composition of the embodiment may include only one type of compound (A) represented by general formula (22), or it may include two or more types. When it includes two or more types, the total amount is preferably within the range specified above.

The maleimide compound (A) used for the embodiment may be a commercially available product. For example, "MIR-5000" by Nippon Kayaku Co., Ltd., can be suitably used as a maleimide compound represented by general formula (6). The compound "X9-450" or "X9-470" by DIC Corporation can be suitably used as a maleimide compound represented by general formula (22).

The content of the maleimide compound (A) of the resin composition of the embodiment is preferably 1 parts by mass or greater and more preferably 5 parts by mass or greater as the lower limit, with the solid resin content in the resin composition as 100 parts by mass. The upper limit is preferably 90 parts by mass or lower, more preferably 60 parts by mass or lower and even more preferably 40 parts by mass or lower, and may even be 30 parts by mass or lower. Within this range, low permittivity, low dielectric loss tangent and satisfactory flexibility can be more effectively obtained.

The maleimide compound (A) used may be a single type or a combination of two or more types. When two or more types are used, the total amount is preferably within the range specified above. Here, unless otherwise specified, the term "solid resin content of the resin composition" refers to the portion of the resin composition without the solvent, and 100 parts by mass of the solid resin content means that the total amount of components in the resin composition without the solvent is considered to be 100 parts by mass.

### Polyphenylene ether compound (B)]

The polyphenylene ether compound (B) of the embodiment is a compound represented by general formula (1). By containing a polyphenylene ether compound (B) having such a structure, the resin composition of the embodiment can exhibit excellent low permittivity and low dielectric loss tangent, and can yield uniform cured products. By using a maleimide compound (A) represented by general formula (22) and a polyphenylene ether compound (B) in combination for the embodiment, it is possible to achieve more excellent dielectric characteristics than by using a conventional maleimide compound and a polyphenylene ether compound (B) in combination. The polyphenylene ether compound (B) represented by general formula (1) used for the embodiment has a number-average molecular weight of 1000 to 7000. The number-average molecular weight can be limited to 7000 or lower to ensure fluidity during molding. If the number-average molecular weight is 1000 or greater, the original excellent dielectric characteristics (low permittivity and low dielectric loss tangent) and heat resistance of the polyphenylene ether resin can be obtained. In order to obtain more excellent fluidity, heat resistance and dielectric characteristics, the number-average molecular weight of the polyphenylene ether compound (B) may be 1100 to 5000. More preferably, the number-average molecular weight of the polyphenylene ether compound (B) may be 4500 or lower, and more preferably the number-average molecular weight of the polyphenylene ether compound (B) is 3000 or lower. The number-average molecular weight is measured using gel permeation chromatography by an established method.

The polyphenylene ether compound (B) represented by general formula (1) used for the embodiment preferably has a minimum melt viscosity of 50,000 Pa·s or lower. If the minimum melt viscosity is 50,000 Pa·s or lower it will be possible to ensure fluidity and to carry out multilayer molding. There is no particular lower limit for the minimum melt viscosity, but it may be 1000 Pa·s or greater, for example.

The polyphenylene ether compound (B) represented by general formula (1) preferably includes a polymer with a structural unit represented by the following general formula (7) . 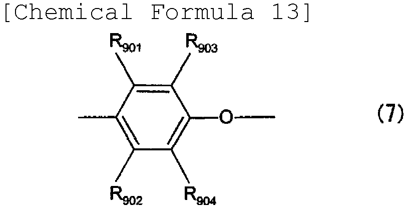 (In general formula (7), R_{901,} R₉₀₂, R₉₀₃ and R₉₀₄ may be the same or different, with each representing an alkyl group of 6 or fewer carbon atoms, an aryl group, a halogen atom or a hydrogen atom.)

The polymer may further include at least one structural unit selected from the group consisting of structural units represented by general formula (8) and general formula (9). 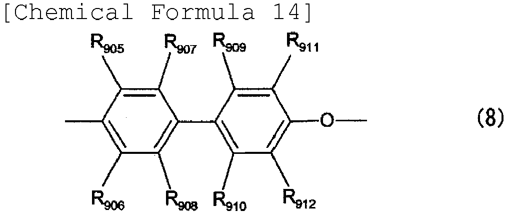 (In general formula (8), R₉₀₅, R₉₀₆, R₉₀₇, R₉₁₁ and R₉₁₂ may be the same or different and each represents an alkyl group of 6 or fewer carbon atoms or a phenyl group. R₉₀₈, R₉₀₉ and R₉₁₀ each independently represent a hydrogen atom, an alkyl group of 6 or fewer carbon atoms or a phenyl group.) 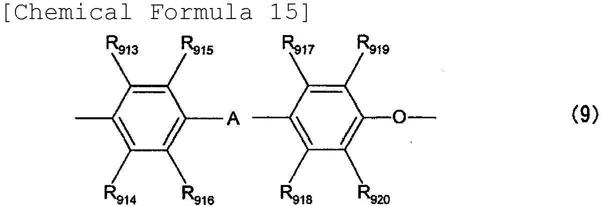 (In general formula (9), R₉₁₃, R₉₁₄, R₉₁₅, R₉₁₆, R₉₁₇, R₉₁₈, R₉₁₉ and R₉₂₀ may be the same or different and each represents a hydrogen atom, an alkyl group of 6 or fewer carbon atoms or a phenyl group. -A- represents a straight-chain, branched or cyclic divalent hydrocarbon group of 20 or fewer carbon atoms.)

In relation to general formula (1), general formulas (8), (9) and (10) are preferably -(Y-O)- of general formula (1), with -(Y-O)- having n₂ (1 to 100) repeating units.

In general formula (1), X represents an aryl group (aromatic group), -(Y-O)n₂- represents a polyphenylene ether portion, R₁, R₂ and R₃ each independently represent a hydrogen atom or an alkyl, alkenyl or alkynyl group, n₂ represents an integer of 1 to 100, n₁ represents an integer of 1 to 6 and n₃ represents an integer of 1 to 4. Preferably, n₁ is an integer of 1 to 4, and more preferably n₁ is 1 or 2, with n₁ ideally being 1. Preferably, n₃ is an integer of 1 to 3, and more preferably n₃ is 1 or 2, with n₃ ideally being 2.

The aryl group for X in general formula (1) may be an aromatic hydrocarbon group. Specifically, it may be a group obtained by removing n₃ hydrogen atoms from a ring structure selected from among benzene ring structures, biphenyl structures, indenyl ring structures and naphthalene ring structures (for example, a phenyl, biphenyl, indenyl or naphthyl group), and it is preferably a biphenyl group. Here, an aryl group may also include a diphenyl ether group having the aryl group bonded to an oxygen atom, or a benzophenone group bonded by a carbonyl group, or a 2,2-diphenylpropane group bonded by an alkylene group. The aryl group may also be optionally substituted with common substituents such as alkyl groups (preferably alkyl groups of 1 to 6 carbon atoms, and especially methyl groups), alkenyl groups, alkynyl groups or halogen atoms. Since the "aryl group" is substituted at the polyphenylene ether portion via an oxygen atom, the numerical limit for substituents will generally depend on the number of polyphenylene ether portions.

The polyphenylene ether compound (B) most preferably includes a polyphenylene ether with the structure represented by the following general formula (10). 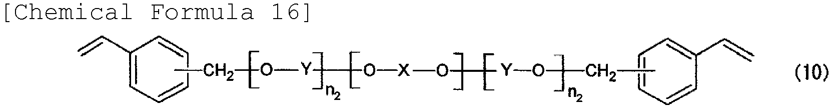 (In general formula (10), X is an aryl group (aromatic group), each -(Y-O)n₂- represents a polyphenylene ether portion and each n₂ represents an integer of 1 to 100.)

-(Y-O)n₂- and n₂ have the same definitions as for general formula (1). Compounds with different n₂ may also be included.

X in general formula (1) and general formula (10) are preferably general formula (11), general formula (12) or general formula (13), and -(Y-O)n₂- in general formula (1) and general formula (10) preferably have structures with general formula (14) or general formula (15) arranged, or more preferably have structures with general formula (14) and general formula (15) randomly arranged. 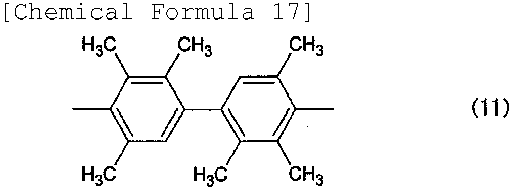 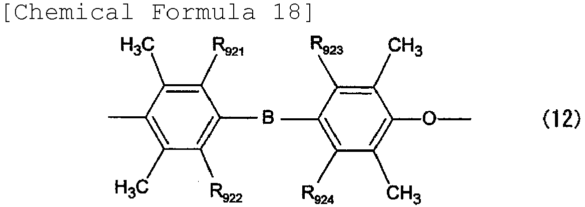 (In general formula (12), R₉₂₁, R₉₂₂, R₉₂₃ and R₉₂₄ each independently represent a hydrogen atom or a methyl group, and -B- is a straight-chain, branched or cyclic divalent hydrocarbon group of 20 or fewer carbon atoms.) 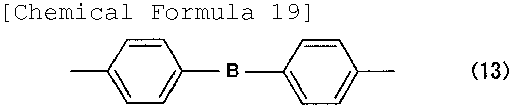 (In general formula (13), -B- is a straight-chain, branched or cyclic divalent hydrocarbon group of 20 or fewer carbon atoms.)

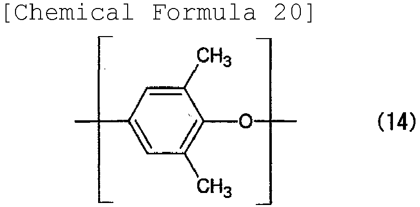

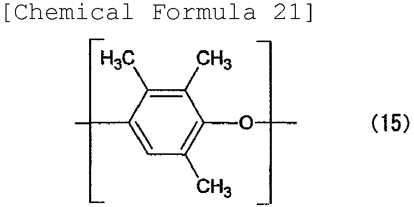

The method for producing the modified polyphenylene ether with a structure represented by general formula (10) is not particularly restricted, and for example, it can be produced by vinylbenzyl etherification of the terminal phenolic hydroxyl groups of a bifunctional phenylene ether oligomer obtained by oxidative coupling of a bifunctional phenol compound and a monofunctional phenol compound.

Such modified polyphenylene ethers are also commercially available, with suitable examples including OPE-2St1200 and OPE-2st2200 by Mitsubishi Gas Chemical Company, Inc.

The content of the polyphenylene ether compound (B) of the resin composition of the embodiment is preferably 1 parts by mass or greater, more preferably 5 parts by mass or greater and even more preferably 8 parts by mass or greater, with respect to the solid resin content in the resin composition as 100 parts by mass. The upper limit for the content is preferably 40 parts by mass or lower, more preferably 30 parts by mass or lower and even more preferably 25 parts by mass or lower. Within this range, low permittivity, low dielectric loss tangent and satisfactory moldability can be more effectively obtained.

The resin composition may contain a single type of polyphenylene ether compound (B), or two or more types. When it includes two or more types, the total amount is preferably within the range specified above.

### Block copolymer with a styrene skeleton (C)]

The "block copolymer with a styrene skeleton (C)" according to the embodiment refers to an elastomer that is a block copolymer having a polystyrene block structure, and it excludes random copolymers. Compounds composed of aromatic vinyl compounds alone are excluded from the "block copolymer with a styrene skeleton (C)." By containing a block copolymer with a styrene skeleton (C), the resin composition of the embodiment can exhibit excellent low permittivity, low dielectric loss tangent and flexibility.

The block copolymer with a styrene skeleton (C) used in the resin composition of the embodiment preferably contains at least one selected from the group consisting of styrene-butadiene block copolymers, styrene-isoprene block copolymers, styrene-hydrogenated butadiene block copolymers, styrene-hydrogenated isoprene block copolymers and styrene-hydrogenated (isoprene/butadiene) block copolymers. These block copolymers may be used alone or in combinations of two or more. Styrene-isoprene block copolymers, styrene-hydrogenated butadiene block copolymers, styrene-hydrogenated isoprene block copolymers and styrene-hydrogenated (butadiene/isoprene) block copolymers are especially preferred for a more excellent low dielectric loss tangent.

The styrene in the polystyrene block structure for the embodiment may have a substituent. Specifically, styrene derivatives such as α-methylstyrene, 3-methylstyrene, 4-propylstyrene and 4-cyclohexylstyrene may be used.

The styrene content of the block copolymer with a styrene skeleton (C) (hereunder also referred to as "styrene ratio") is not particularly restricted but is preferably 10 mass% or greater and more preferably 20 mass% or greater. The upper limit for the styrene content is not particularly restricted as long as it is less than 100 mass%, but it is preferably less than 99 mass% and more preferably 70 mass% or lower. Within this range, the solvent solubility and compatibility with other compounds will tend to be further improved. Here, the styrene content is the value represented by: (a)/(b) × 100 (units: %), where the mass of styrene units in the block copolymer with a styrene skeleton (C) is (a) g and the total mass of the block copolymer with a styrene skeleton (C) is (b) g.

The content of the block copolymer with a styrene skeleton (C) of the resin composition of the embodiment is preferably 1 parts by mass or greater, more preferably 5 parts by mass or greater and even more preferably 8 parts by mass or greater, with respect to the solid resin content in the resin composition as 100 parts by mass. The upper limit for the content is preferably 30 parts by mass or lower, more preferably 25 parts by mass or lower and even more preferably 22 parts by mass or lower. Within this range, excellent low permittivity, low dielectric loss tangent and moldability can be more effectively obtained. The resin composition may include only one type of block copolymer with a styrene skeleton (C), or it may include two or more types. When it includes two or more types, the total amount is preferably within the range specified above.

The block copolymer with a styrene skeleton (C) used for the embodiment may be a commercial product. TR2630 (by JSR Corporation) and TR2003 (by JSR Corporation) may be mentioned as examples of styrene-butadiene-styrene block copolymers. SIS5250 may be mentioned as an example of a styrene-isoprene-styrene block copolymer (by JSR Corporation). SEPTON2104 (by Kuraray Co., Ltd.) may be mentioned as an example of a styrene-hydrogenated isoprene-styrene block copolymer.

### Maleimide compound (D)]

Preferably, the resin composition of the embodiment further contains a maleimide compound (D) other than the maleimide compound (A). The maleimide compound (D) preferably contains at least one selected from the group consisting of the following general formulas (2), (3), (4) and (5), for example. This can improve the low thermal expansion and heat resistance. The [maleimide compound (D)] used for the embodiment is distinct from and not included within the [maleimide compound (A)].

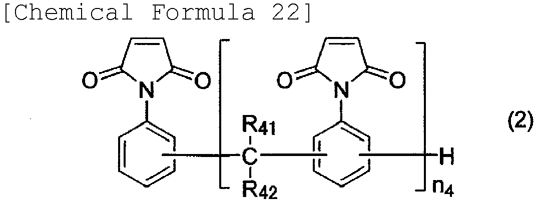

In general formula (2), R₄₁ and R₄₂ each independently represent a hydrogen atom or methyl group, and are preferably hydrogen atoms. In general formula (2), n₄ represents an integer of 1 or greater, the upper limit for n₄ usually being 10, and the upper limit for n₄ preferably being 7 and more preferably 5 from the viewpoint of solubility in organic solvents. The compound represented by general formula (2) may also include two or more compounds with different n₄.

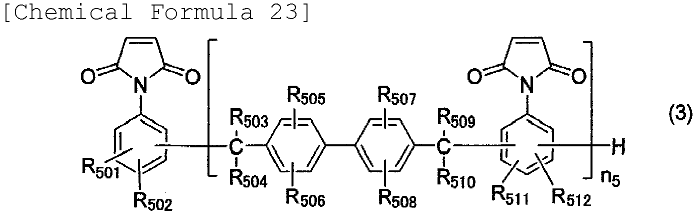

In general formula (3), R₅₀₁, R₅₀₂, R₅₀₃, R₅₀₄, R₅₀₅, R₅₀₆, R₅₀₇, R₅₀₈, R₅₀₉, R₅₁₀, R₅₁₁ and R₅₁₂ each independently represent a hydrogen atom, an alkyl group of 1 to 8 carbon atoms (such as methyl, ethyl, n-propyl, isopropyl, n-butyl, isobutyl, t-butyl or n-pentyl), or a phenyl group. A group selected from the group consisting of hydrogen atoms and methyl and phenyl groups is preferred from the viewpoint of improving flame resistance and metal foil (copper foil) peel strength, a hydrogen atom or methyl group is more preferred, and a hydrogen atom is even more preferred, among those mentioned above.

In general formula (3), n₅ is an integer between 1 and 10. From the viewpoint of more excellent solvent solubility, n₅ is preferably 4 or less, more preferably 3 or less and even more preferably 2 or less. The compound represented by general formula (3) may also include two or more compounds with different n₅.

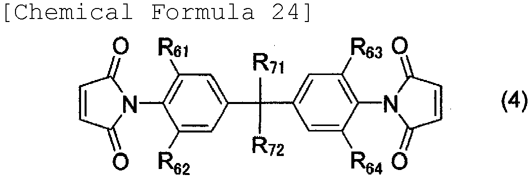

In general formula (4), R₆₁, R₆₂, R₆₃ and R₆₄ each independently represent a hydrogen atom or a methyl or ethyl group, and R₇₁ and R₇₂ each independently a hydrogen atom or a methyl group. From the viewpoint of more excellent low permittivity and low dielectric loss tangent, R₆₁, R₆₂, R₆₃ and R₆₄ are each preferably a methyl or ethyl group. An example of such a compound is 3,3'-diethyl-5,5'-dimethyl-4,4'-diphenylmethanebismaleimide.

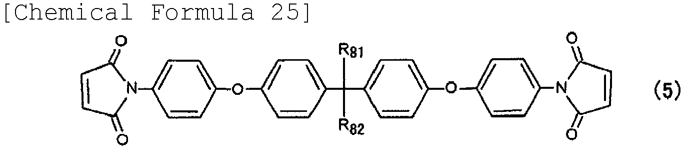

In general formula (5), R₈₁ and R₈₂ each independently represent a hydrogen atom or a methyl or ethyl group. From the viewpoint of more excellent low permittivity and low dielectric loss tangent, R₈₁ and R₈₂ are each preferably a methyl group. An example of such a compound is 2,2-bis(4-(4-maleimidephenoxy)-phenyl)propane.

The maleimide compound (D) used for the embodiment may be a commercially available product, suitable examples of which include "BMI-2300" by Daiwa Kasei Chemicals Co., Ltd., as a maleimide compound represented by general formula (2), "MIR-3000" by Nippon Kayaku Co., Ltd., as a maleimide compound represented by general formula (3), "BMI-70" by K.I Chemical Industry Co., Ltd., as a maleimide compound represented by general formula (4), and "BMI-80" by K.I Chemical Industry Co., Ltd., as a maleimide compound represented by general formula (5).

The content of the maleimide compound (D) in the resin composition of the embodiment is not particularly restricted and may be appropriately set for the desired properties. The maleimide compound (D) content, when present, is preferably 1 parts by mass or greater and more preferably 5 parts by mass or greater, with the solid resin content in the resin composition as 100 parts by mass. The upper limit is preferably 90 parts by mass or lower, more preferably 60 parts by mass or lower and even more preferably 40 parts by mass or lower, and may even be 30 parts by mass or lower. Within this range, high heat resistance and low water absorption will tend to be more effectively exhibited.

The maleimide compound (D) used may be a single type or a combination of two or more types. When two or more types are used, the total amount is preferably within the range specified above.

### Flame retardant (E)]

The resin composition of the embodiment preferably includes a flame retardant (E) to improve the flame resistance. The flame retardant (E) used for the embodiment may be a known compound, examples of which include halogen-based flame retardants such as brominated epoxy resins, brominated polycarbonates, brominated polystyrenes, brominated styrenes, brominated phthalimides, tetrabromobisphenol A, pentabromobenzyl (meth)acrylate, pentabromotoluene, tribromophenol, hexabromobenzene, decabromodiphenyl ether, bis-1,2-pentabromophenylethane, chlorinated polystyrene and chlorinated paraffins, phosphorus-based flame retardants such as red phosphorus, tricresyl phosphate, triphenyl phosphate, cresyldiphenyl phosphate, trixylenyl phosphate, trialkyl phosphates, dialkyl phosphates, tris(chloroethyl)phosphate, phosphazene, 1,3-phenylenebis(2,6-dixylenyl phosphate) and 10-(2,5-dihydroxyphenyl)-10H-9-oxa-10-phosphaphenanthrene-10-oxide, inorganic flame retardants such as aluminum hydroxide, magnesium hydroxide, partial boehmite, boehmite, zinc borate and antimony trioxide, and silicone-based flame retardants such as silicone rubber and silicone resins. These flame retardants may be used alone or in combinations of two or more. Phosphorus-based flame retardants are preferred among these, with 1,3-phenylenebis(2,6-dixylenyl phosphate) being especially preferred because it has less impairment of its low dielectric characteristics. The phosphorus content of the resin composition is preferably 0.1 mass% to 5 mass%.

The flame retardant (E) content, when present, is preferably 1 part by mass or greater and more preferably 5 parts by mass or greater, with respect to the solid resin content in the resin composition as 100 parts by mass. The upper limit for the content is preferably 30 parts by mass or lower, more preferably 20 parts by mass or lower and even more preferably 15 parts by mass or lower. The flame retardant (E) used may be a single type or a combination of two or more types. When two or more types are used, the total amount is preferably within the range specified above.

### Cyanic acid ester compound (F)]

The cyanic acid ester compound (F) of the embodiment is not particularly restricted as long as it is a resin having in the molecule an aromatic portion substituted with at least one cyanato group (cyanic acid ester group).

The cyanic acid ester compound (F) of the embodiment may be a compound represented by general formula (23), for example. 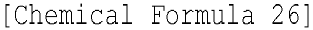 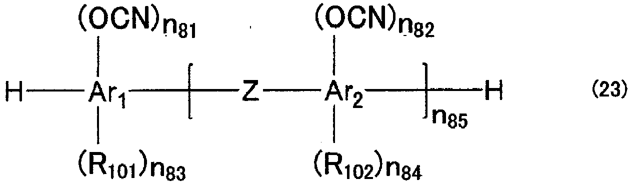 (Ar₁ and Ar₂ in general formula (23) each independently represent an optionally substituted phenylene group, optionally substituted naphthylene group or optionally substituted biphenylene group. R₁₀₁ and R₁₀₂ are each independently selected from among a hydrogen atom, an optionally substituted alkyl group of 1 to 6 carbon atoms, an optionally substituted aryl group of 6 to 12 carbon atoms, an optionally substituted alkoxy group of 1 to 4 carbon atoms, an aralkyl group optionally substituted with a group having an alkyl group of 1 to 6 carbon atoms and an aryl group of 6 to 12 carbon atoms bonded together, or an alkylaryl group optionally substituted with a group having an alkyl group of 1 to 6 carbon atoms and an aryl group of 6 to 12 carbon atoms bonded together. n₈₁ represents the number of cyanato groups bonded to Ar₁, and it is an integer of 1 to 3. n₈₂ represents the number of cyanato groups bonded to Ar₂, and it is an integer of 1 to 3. n₈₃ represents the number of R₁₀₁ groups bonded to Ar₁, and is 4 - n₈₁ when Ar₁ is a phenylene group, 6 - n₈₁ when it is a naphthylene group or 8 - n₈₁ when it is a biphenylene group. n₈₄ represents the number of R₁₀₂ groups bonded to Ar₂, and is 4 - n₈₂ when Ar₂ is a phenylene group, 6 - n₈₂ when it is a naphthylene group or 8 - n₈₂ when it is a biphenylene group. n₈₅ represents the average number of repeats, and is an integer of 0 to 50. The cyanic acid ester compound (F) may be a mixture of compounds with different n₈₅. Each Z is independently selected from among a single bond, a divalent organic group of 1 to 50 carbon atoms (optionally with a heteroatom substituting a hydrogen atom), a divalent organic group of 1 to 10 nitrogen atoms (such as -N-R-N-), or a carbonyl group (-CO-), carboxy group (-C(=O)O-), carbonyl dioxide group (-OC(=O)O-), sulfonyl group (-SO₂-), divalent sulfur atom or divalent oxygen atom.

The alkyl group in R₁₀₁ or R₁₀₂ of general formula (23) may have a straight-chain structure, branched-chain structure or cyclic structure (cycloalkyl group, etc.). The hydrogen atoms in the alkyl groups of general formula (23) and the aryl groups of R₁₀₁ and R₁₀₂ may be optionally substituted with halogen atoms such as fluorine atoms or chlorine atoms, alkoxy groups such as methoxy or phenoxy groups, or cyano groups.

Specific examples of alkyl groups include methyl, ethyl, propyl, isopropyl, n-butyl, isobutyl, tert-butyl, n-pentyl, 1-ethylpropyl, 2,2-dimethylpropyl, cyclopentyl, hexyl, cyclohexyl and trifluoromethyl groups.

Specific examples of aryl groups include phenyl, xylyl, mesityl, naphthyl, phenoxyphenyl, ethylphenyl, o-, m- or p-fluorophenyl, dichlorophenyl, dicyanophenyl, trifluorophenyl, methoxyphenyl, and o-, m- or p-tolyl groups.

Specific examples of alkoxy groups include methoxy, ethoxy, propoxy, isopropoxy, n-butoxy, isobutoxy and tert-butoxy groups.

Specific examples of divalent organic groups for Z in general formula (23) include methylene, ethylene, trimethylene, cyclopentylene, cyclohexylene, trimethylcyclohexylene, biphenylylmethylene, dimethylmethylene-phenylene-dimethylmethylene, fluorenediyl and phthalidediyl groups. The hydrogen atoms in the divalent organic groups may be optionally substituted with halogen atoms such as fluorine atoms or chlorine atoms, alkoxy groups such as methoxy or phenoxy groups, or cyano groups. Divalent organic groups of 1 to 10 nitrogen atoms for Z in general formula (23) include imino and polyimide groups.

Z in general formula (23) may also have a structure represented by general formula (24) or general formula (25) below. 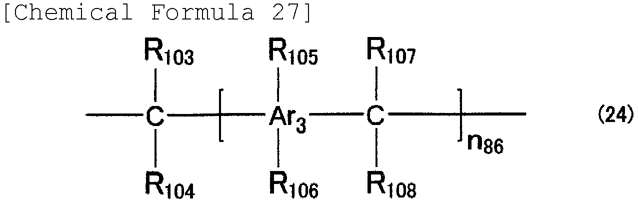 (In general formula (24), Ar₃ is selected from among phenylene, naphthylene and biphenylene groups. R₁₀₃, R₁₀₄, R₁₀₇ and R₁₀₈ each independently are selected from among hydrogen atoms, alkyl groups of 1 to 6 carbon atoms, aryl groups of 6 to 12 carbon atoms and aryl groups substituted with at least one trifluoromethyl or phenolic hydroxyl group. R₁₀₅ and R₁₀₆ are each independently selected from among hydrogen atoms, alkyl groups of 1 to 6 carbon atoms, aryl groups of 6 to 12 carbon atoms, alkoxy groups of 1 to 4 carbon atoms and hydroxyl groups. n₈₆ represents an integer of 0 to 5, but the cyanic acid ester compound (F) may also be a mixture of compounds having groups with different n₈₆.) 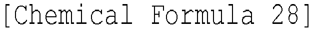 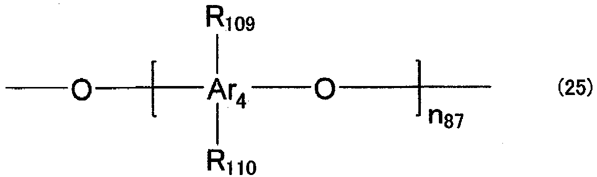 (In general formula (25), Ar₄ is selected from among phenylene, naphthylene and biphenylene groups. R₁₀₉ and R₁₁₀ are each independently selected from among hydrogen atoms, alkyl groups of 1 to 6 carbon atoms, aryl groups of 6 to 12 carbon atoms, benzyl groups, alkoxy groups of 1 to 4 carbon atoms, and aryl groups substituted with at least one hydroxyl group, trifluoromethyl group or cyanato group. n₈₇ represents an integer of 0 to 5, but the cyanic acid ester compound (F) may also be a mixture of compounds having groups with different n₈₇.)

In addition, Z in general formula (23) may be a divalent group represented by the following formula. 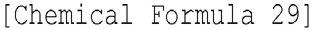 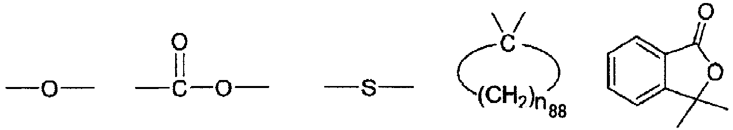 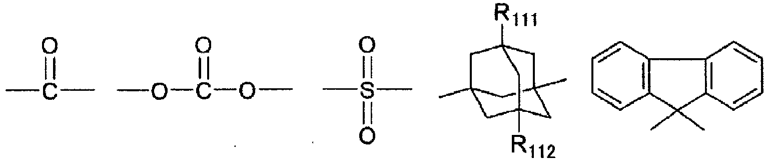 (In the formula, n₈₈ represents an integer of 4 to 7. R₁₁₁ and R₁₁₂ each independently represent a hydrogen atom or an alkyl group of 1 to 6 carbon atoms.)

Specific examples for Ar₃ in general formula (24) and Ar₄ in general formula (25) include 1,4-phenylene, 1,3-phenylene, 4,4'-biphenylene, 2,4'-biphenylene, 2,2'-biphenylene, 2,3'-biphenylene, 3,3'-biphenylene, 3,4'-biphenylene, 2,6-naphthylene, 1,5-naphthylene, 1,6-naphthylene, 1,8-naphthylene, 1,3-naphthylene and 1,4-naphthylene groups. The alkyl and aryl groups for R₁₀₃ to R₁₀₈ in general formula (24) and R₁₀₉ and R₁₁₀ in general formula (25) are the same as those mentioned for general formula (23).

Examples of cyanic acid ester compounds represented by general formula (23) include phenol-novolac-type cyanic acid ester compounds, naphtholaralkyl-type cyanic acid ester compounds, biphenylaralkyl-type cyanic acid ester compounds, naphthylene ether-type cyanic acid ester compounds, xylene resin-type cyanic acid ester compounds, adamantane backbone-type cyanic acid ester compounds, bisphenol A-type cyanic acid ester compounds, diallylbisphenol A-type cyanic acid ester compounds and naphtholaralkyl-type cyanic acid ester compounds.

Specific examples of cyanic acid ester compounds represented by general formula (23) include, but are not particularly limited to, cyanatobenzene, 1-cyanato-2-, 1-cyanato-3- or 1-cyanato-4-methylbenzene, 1-cyanato-2-, 1-cyanato-3- or 1-cyanato-4-methoxybenzene, 1-cyanato-2,3-, 1-cyanato-2,4-, 1-cyanato-2,5-, 1-cyanato-2,6-, 1-cyanato-3,4- or 1-cyanato-3,5-dimethylbenzene, cyanatoethylbenzene, cyanatobutylbenzene, cyanatooctylbenzene, cyanatononylbenzene, 2-(4-cyanophenyl)-2-phenylpropane (cyanate of 4-α-cumylphenol), 1-cyanato-4-cyclohexylbenzene, 1-cyanato-4-vinylbenzene, 1-cyanato-2- or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene (cyanate of eugenol), methyl(4-cyanatophenyl)sulfide, 1-cyanato-3-trifluoromethylbenzene, 4-cyanatobiphenyl, 1-cyanato-2- or 1-cyanato-4-acetylbenzene, 4-cyanatobenzaldehyde, methyl 4-cyanatobenzoate ester, phenyl 4-cyanatobenzoate ester, 1-cyanato-4-acetoaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-dimethylbenzene, 1,3-dicyanato-2,4,6-trimethylbenzene, 1,3-dicyanato-5-methylbenzene, 1-cyanato or 2-cyanatonaphthalene, 1-cyanato4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6- or 2,7-dicyanatodinaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(3-allyl-4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl)ether, bis(4-cyanatophenyl)sulfide, bis(4-cyanatophenyl)sulfone, -4-cyanatophenyl 4-cyanatobenzoate ester(4-cyanatophenyl-4-cyanatobenzoate), bis-(4-cyanatophenyl)carbonate, 1,3-bis(4-cyanatophenyl)adamantane, 1,3-bis(4-cyanatophenyl)-5,7-dimethyladamantane, 3,3-bis(4-cyanatophenyl)isobenzofuran-1(3H)-one (cyanate of phenolphthalein), 3,3-bis(4-cyanato-3-methylphenyl)isobenzofuran-1(3H)-one (cyanate of o-cresolphthalein), 9,9-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methylanilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimide, tris(3,5-dimethyl-4-cyanatobenzyl)isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, phenol-novolac resins, cyanic acid esterified forms, obtained by the method as described above, of phenol resins such as cresol-novolac resins (obtained by reacting a phenol, alkyl-substituted phenol or halogen-substituted phenol with a formaldehyde compound such as formalin or paraformaldehyde in an acidic solution by a known method), trisphenol-novolac resins (obtained by reacting hydroxybenzaldehyde with a phenol in the presence of an acidic catalyst), fluorene-novolac resins (obtained by reacting a fluorenone compound with a 9,9-bis(hydroxyaryl)fluorene in the presence of an acidic catalyst), phenolaralkyl resins, cresolaralkyl resins, naphtholaralkyl resins, and biphenylaralkyl resins (obtained by reacting a bishalogenomethyl compound such as one represented by Ar₅-(CH₂Z')₂ with a phenol compound either with an acidic catalyst or without a catalyst, or obtained by reacting a bis(alkoxymethyl) compound such as one represented by Ar₅-(CH₂OR)₂ or a bis(hydroxymethyl) compound such as represented by Ar₅-(CH₂OH)₂ with a phenol compound in the presence of an acidic catalyst, or obtained by polycondensation of an aromatic aldehyde compound, an aralkyl compound and a phenol compound, by a known method), phenol-modified xyleneformaldehyde resins (obtained by reacting a xyleneformaldehyde resin with a phenol compound in the presence of an acidic catalyst by a known method), modified-naphthaleneformaldehyde resins (obtained by reacting a naphthaleneformaldehyde resin with a hydroxy-substituted aromatic compound in the presence of an acidic catalyst, by a known method), phenol-modified dicyclopentadiene resins, and phenol resins having a polynaphthylene ether structure (obtained by dehydrating condensation of a polyhydric hydroxynaphthalene compound having two or more phenolic hydroxyl groups in the molecule, in the presence of a basic catalyst by a known method). These cyanic acid ester compounds may be used alone or in combinations of two or more.

Preferred among these are phenol-novolac-type cyanic acid ester compounds, naphtholaralkyl-type cyanic acid ester compounds, naphthylene ether-type cyanic acid ester compounds, bisphenol A-type cyanic acid ester compounds, bisphenol M-type cyanic acid ester compounds and diallylbisphenol-type cyanic acid ester compounds, with naphtholaralkyl-type cyanic acid ester compounds being especially preferred.

Cured resin compositions obtained using these cyanic acid ester compounds have excellent properties including heat resistance and copper foil adhesiveness.

The content of the cyanic acid ester compound (F) in the resin composition of the embodiment is not particularly restricted and may be appropriately set for the desired properties. Specifically, the cyanic acid ester compound (F) content is preferably 0.1 part by mass or greater, more preferably 0.5 part by mass or greater, even more preferably 1 part by mass or greater, or even 3 parts by mass or greater or 5 parts by mass or greater, with the solid resin content in the resin composition as 100 parts by mass. The upper limit for the content is preferably 90 parts by mass or lower, more preferably 80 parts by mass or lower, even more preferably less than 70 parts by mass, yet more preferably 60 parts by mass or lower, or even 50 parts by mass or lower or 40 parts by mass or lower. Within this range, more excellent low permittivity and low dielectric loss tangent can be provided.

These cyanic acid ester compound (F) used may be a single type or a combination of two or more types. When two or more types are used, the total amount is preferably within the range specified above.

### [Other components]

In the resin composition of the embodiment, a polyphenylene ether compound other than the polyphenylene ether compound (B), an epoxy compound, phenol compound, oxetane resin or benzoxazine compound, or a thermoplastic elastomer not mentioned above for the block copolymer with a styrene skeleton (C) (hereunder referred to as "other thermoplastic elastomer"), a filler (G), curing accelerator or organic solvent, etc., may be contained within ranges that allow the desired properties to be obtained. Using these in combination can improve the desired properties such as low permittivity, low dielectric loss tangent, flame resistance and low thermal expansion.

The resin composition of the embodiment contains a polyphenylene ether compound other than the polyphenylene ether compound (B), and the other thermoplastic elastomer, in a total amount of preferably 3 mass% or lower and more preferably 1 mass% or lower of the solid resin content. With such a construction, the effect of the invention will be more effectively exhibited.

### [Epoxy compound]

The epoxy compound is not particularly restricted as long as it is a compound or resin having one or more (preferably 2 to 12, more preferably 2 to 6, even more preferably 2 to 4, yet more preferably 2 or 3 and even yet more preferably 2) epoxy groups in the molecule, and it may be any compound commonly used in the field of printed wiring boards.

Examples of epoxy compounds include epoxified compounds with double bonds, such as bisphenol A-type epoxy resins, bisphenol E-type epoxy resins, bisphenol F-type epoxy resins, bisphenol S-type epoxy resins, phenol-novolac-type epoxy resins, bisphenol A novolac-type epoxy resins, glycidyl ester-type epoxy resins, aralkylnovolac-type epoxy resins, biphenylaralkyl-type epoxy resins, naphthylene ether-type epoxy resins, cresol-novolac-type epoxy resins, polyfunctional phenol-type epoxy resins, naphthalene-type epoxy resins, anthracene-type epoxy resins, naphthalene backbone-modified novolac-type epoxy resins, phenolaralkyl-type epoxy resins, naphtholaralkyl-type epoxy resins, dicyclopentadiene-type epoxy resins, biphenyl-type epoxy resins, alicyclic epoxy resins, polyol-type epoxy resins, phosphorus-containing epoxy resins, glycidylamines, glycidyl esters and butadiene, and compounds obtained by reacting hydroxyl-containing silicone resins with epichlorohydrin. These epoxy resins may be used alone or in combinations of two or more. Biphenylaralkyl-type epoxy resins, naphthylene ether-type epoxy resins, polyfunctional phenol-type epoxy resins and naphthalene-type epoxy resins are preferred among the above from the viewpoint of further improving the flame retardance and heat resistance.

### [Phenol compound]

The phenol compound is not particularly restricted as long as it is a compound or resin having one or more (preferably 2 to 12, more preferably 2 to 6, even more preferably 2 to 4, yet more preferably 2 or 3 and even yet more preferably 2) phenolic hydroxyl groups in the molecule, and examples include bisphenol A-type phenol resins, bisphenol E-type phenol resins, bisphenol F-type phenol resins, bisphenol S-type phenol resins, phenol-novolac resins, bisphenol A novolac-type phenol resins, glycidyl ester-type phenol resins, aralkyl-novolac-phenol resins, biphenylaralkyl-type phenol resins, cresol-novolac-type phenol resins, polyfunctional phenol resins, naphthol resins, naphthol-novolac resins, polyfunctional naphthol resins, anthracene-type phenol resins, naphthalene backbone-modified novolac-type phenol resins, phenolaralkyl-type phenol resins, naphtholaralkyl-type phenol resins, dicyclopentadiene-type phenol resins, biphenyl-type phenol resins, alicyclic phenol resins, polyol-type phenol resins and phosphorus-containing phenol resins. These phenol resins may be used alone or in combinations of two or more. One or more selected from the group consisting of biphenylaralkyl-type phenol resins, naphtholaralkyl-type phenol resins, phosphorus-containing phenol resins and hydroxyl-containing silicone resins are preferred from the viewpoint of further improving the flame resistance.

### [Oxetane resin]

The oxetane resin is not particularly restricted, and examples include oxetane, alkyloxetanes (such as 2-methyloxetane, 2,2-dimethyloxetane, 3-methyloxetane and 3,3-dimethyloxetane), 3-methyl-3-methoxymethyloxetane, 3,3-di(trifluoromethyl)perfluorooxy, 2-chloromethyloxetane, 3,3-bis(chloromethyl)oxetane, biphenyl-type oxetane, OXT-101 (product of Toagosei Co., Ltd.) and OXT-121 (product of Toagosei Co., Ltd.). These oxetane resins may be used alone or in combinations of two or more.

### [Benzoxazine compound]

The benzoxazine compound is not particularly restricted as long as it is a compound having two or more dihydrobenzoxazine rings in the molecule, and examples include bisphenol A-type benzoxazine BA-BXZ (product of Konishi Chemical Ind. Co., Ltd.), bisphenol F-type benzoxazine BF-BXZ (product of Konishi Chemical Ind. Co., Ltd.) and bisphenol S-type benzoxazine BS-BXZ (product of Konishi Chemical Ind. Co., Ltd.). These benzoxazine compounds may be used alone or in combinations of two or more.

### [Other thermoplastic elastomer]

The "other thermoplastic elastomer" is distinct from the "block copolymer with a styrene skeleton (C)." A "block copolymer with a styrene skeleton (C)" is an elastomer that is a block copolymer having a polystyrene block structure, while the "other thermoplastic elastomer" is any other elastomer. In other words, it corresponds to a random copolymer or a block copolymer without a styrene skeleton. Examples for the other thermoplastic elastomer include one or more selected from the group consisting of polyisoprene, polybutadiene, styrene-butadiene random copolymers, butyl rubber, ethylene-propylene rubber, fluorine rubber, silicone rubber, and their hydrogenated forms, and their alkylated forms. One or more selected from the group consisting of polyisoprene, polybutadiene, styrene-butadiene random copolymers, butyl rubber and ethylene-propylene rubber are more preferred from the viewpoint of excellent compatibility with the polyphenylene ether compound (B).

### [Filler (G)]

The filler (G) may be any publicly known compound suitable for use with no particular restrictions on its type, and it may be any one commonly used in the field. Specific examples include inorganic fillers, for example, silicas such as natural silica, molten silica, synthetic silica, amorphous silica, AEROSIL and hollow silica, white carbon, titanium white, zinc oxide, magnesium oxide, zirconium oxide, boron nitride, aggregated boron nitride, silicon nitride, aluminum nitride, barium sulfate, aluminum hydroxide, heat treated aluminum hydroxide products (aluminum hydroxide that has been heat treated to partially reduce water of crystallization), metal hydrates such as boehmite and magnesium hydroxide, molybdenum compounds such as molybdenum oxide and zinc molybdate, zinc borate, zinc stannate, alumina, clay, kaolin, talc, fired clay, calcined kaolin, fired talc, mica, E-glass, A-glass, NE-glass, C-glass, L-glass, D-glass, S-glass, M-glass G20, glass staple fibers (including glass fine powders of E-glass, T-glass, D-glass, S-glass or Q-glass), hollow glass and spherical glass, as well as organic fillers such as styrene-type, butadiene-type and acrylic rubber powders, core-shell rubber powders, silicone resin powders, silicone rubber powders and silicone complex powders. These fillers may be used alone or in combinations of two or more.

One or more selected from the group consisting of silica, aluminum hydroxide, boehmite, magnesium oxide and magnesium hydroxide are preferred among these. Using such compounds as the filler (G) improves the properties including the thermal expansion property, dimensional stability and flame retardance of the resin composition.

The content of the filler (G) in the resin composition is not particularly restricted and may be appropriately set for the desired properties. The filler (G) content, when present, is preferably 50 parts by mass or greater, with the solid resin content in the resin composition as 100 parts by mass. The upper limit for the content of the filler (G) is preferably 1600 parts by mass or lower, more preferably 500 parts by mass or lower and most preferably 300 parts by mass or lower, with 100 parts by mass as the solid resin content of the resin composition. Alternatively, the filler (G) may be present at 75 parts by mass to 250 parts by mass, or at 100 parts by mass to 200 parts by mass. A filler (G) content within this range will provide satisfactory moldability for the resin composition.

The resin composition may contain a single type of filler (G), or two or more types. When it includes two or more types, the total amount is preferably within the range specified above.

The filler (G) is preferably used in combination with one or more selected from the group consisting of silane coupling agents and wet dispersants. The silane coupling agent used may be any one commonly used for surface treatment of inorganic materials, and its type is not particularly restricted. Specifically, there may be mentioned aminosilanes such as γ-aminopropyltriethoxysilane and N-β-(aminoethyl)-γ-aminopropyltrimethoxylane, epoxysilanes such as γ-glycidoxypropyltrimethoxysilane and β-(3,4-epoxycyclohexyl)ethyltrimethoxysilane, vinylsilanes such as γ-methacryloxypropyltrimethoxysilane and vinyl-tri(β-methoxyethoxy)silane, cationic silanes such as N-β-(N-vinylbenzylaminoethyl)-γ-aminopropyltrimethoxysilanehydrochloric acid, and phenylsilanes. A single silane coupling agent may be used alone, or two or more may be used in combination. The wet dispersant used may be any one commonly used for coating, and its type is not particularly restricted. It is preferred to use a copolymer base wet dispersant, specific examples of which include Disperbyk-110, 111, 161, 180, 2009, 2152, BYK-W996, BYK-W9010, BYK-W903 and BYK-W940 by Byk-Chemie, Japan. These wet dispersants may be used alone or in combinations of two or more.

The silane coupling agent content is not particularly restricted, and may be about 1 part by mass to 5 parts by mass with respect to the solid resin content in the resin composition as 100 parts by mass. The dispersant (especially wet dispersant) content is not particularly restricted, and may be, for example, about 0.5 part by mass to 5 parts by mass with respect to the solid resin content in the resin composition as 100 parts by mass.

### [Curing accelerator]

The resin composition of the embodiment may contain a curing accelerator to appropriately adjust the curing speed. Curing accelerators include those commonly used as curing accelerators, such as maleimide compounds, cyanic acid ester compounds and epoxy compounds, including organometallic salts (such as zinc octylate, zinc naphthenate, cobalt naphthenate, copper naphthenate, acetylacetone iron, nickel octylate and manganese octylate), phenol compounds (such as phenol, xylenol, cresol, resorcin, catechol, octylphenol and nonylphenol), alcohols (such as 1-butanol and 2-ethylhexanol), imidazoles (such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole and 2-phenyl-4-methyl-5-hydroxymethylimidazole), as well as carboxylic acid or acid anhydride addition product derivatives of these imidazoles, amines (such as dicyandiamide, benzyldimethylamine and 4-methyl-N,N-dimethylbenzylamine), phosphorus compounds (such as phosphine-based compounds, phosphine oxide-based compounds, phosphonium salt-based compounds and diphosphine-based compounds), epoxy-imidazole adduct compounds, peroxides (such as benzoyl peroxide, p-chlorobenzoyl peroxide, di-t-butyl peroxide, diisopropyl peroxycarbonate and di-2-ethylhexylperoxycarbonate), and azo compounds (such as azobisisobutyronitrile). These curing accelerators may be used alone or in combinations of two or more.

The curing accelerator content is not particularly restricted, and may be about 0.005 part by mass to 10 parts by mass with respect to the solid resin content in the resin composition as 100 parts by mass.

The resin composition of the embodiment may also contain various polymer compounds such as other thermosetting resins, thermoplastic resins and their oligomers, or other additives, in addition to the components mentioned above. Such additives include ultraviolet absorbers, antioxidants, photopolymerization initiators, fluorescent whitening agents, photosensitizers, dyes, pigments, thickeners, flow adjusters, lubricants, antifoaming agents, dispersants, leveling agents, brighteners and polymerization inhibitors. These additives may be used alone or in combinations of two or more.

### [Organic solvent]

The resin composition of the embodiment may also contain an organic solvent. In this case, the resin composition of the embodiment will be in a form with at least a portion, or preferably, all of the resin components mentioned above dissolved or compatibilized in an organic solvent (a solution or varnish). The organic solvent is not particularly restricted as long as it is a polar organic solvent or nonpolar organic solvent that is able to dissolve or compatibilize all or at least a portion of the resin components mentioned above, and examples of polar organic solvents include ketones (such as acetone, methyl ethyl ketone and methyl isobutyl ketone), cellosolves (such as propyleneglycol monomethyl ether and propyleneglycol monomethyl ether acetate), esters (such as ethyl lactate, methyl acetate, ethyl acetate, butyl acetate, isoamyl acetate, ethyl lactate, methyl methoxypropionate and methyl hydroxyisobutyrate), and amides (such as dimethoxyacetamide and dimethylformamide), while examples of nonpolar organic solvents include aromatic hydrocarbons (such as toluene and xylene). These organic solvents may be used alone or in combinations of two or more.

### [Preparation of resin composition]

The resin composition of the embodiment can be prepared by a common method, the preparation method having no particular restrictions as long as it is a method that can produce a resin composition having an aromatic ring in the main backbone and homogeneously containing a maleimide compound (A) exhibiting a relative permittivity of lower than 2.7 at 10 GHz, a polyphenylene ether compound (B) with a number-average molecular weight of 1000 to 7000 represented by general formula (1), a block copolymer with a styrene skeleton (C), and the aforementioned other optional components, when cured alone. For example, by mixing the maleimide compound (A), the polyphenylene ether compound (B) represented by general formula (1) and the block copolymer with a styrene skeleton (C) in that order in a solvent and thoroughly stirring, it is possible to easily prepare a resin composition of the embodiment. The sum of the masses of the maleimide compound (A), polyphenylene ether compound (B) represented by general formula (1) and block copolymer with a styrene skeleton (C) in the resin composition of the embodiment constitutes preferably 40 mass% or greater, more preferably 45 mass% or greater and even 50 mass% or greater, of the solid resin content of the resin composition.

### [Usage]

The resin composition of the embodiment can be suitably used as a material for a resin sheet, prepreg, printed wiring board insulating layer, laminated sheet or semiconductor package.

### [Resin sheet]

The resin sheet of the embodiment has a support and a layer from the resin composition of the embodiment disposed on the surface of the support. The resin sheet can be used as a build-up film or dry film solder resist. The method for producing the resin sheet is not particularly restricted, and an example is a method of coating (applying) and drying a solution of the resin composition of the embodiment in a solvent onto a support to obtain a resin sheet.

Examples for supports to be used include polyethylene films, polypropylene films, polycarbonate films, polyethylene terephthalate films, ethylene-tetrafluoroethylene copolymer films and releasable films having release agents coated on the surfaces of such films, organic film base materials such as polyimide films, conductive foils such as copper foils and aluminum foils, and laminar forms such as glass plates, SUS sheets and FRPs, with no particular restrictions. For a copper foil, the ten-point height of irregularities Rz is preferably 0.3 µm to 10 µm on the surface of the copper foil on the side where the layer formed of the resin composition of the embodiment is disposed. A value of 0.3 µm or greater can further improve the plating adhesion. If it is greater than 10 µm, then the thickness of the layer formed of the resin composition of the embodiment must be increased to ensure the insulating property. A more preferred range for the ten-point height of irregularities Rz on the surface of the copper foil is 0.6 µm to 2.5 µm, for example. The ten-point height of irregularities Rz on the surface of the copper foil is preferably smaller than the thickness of the layer formed of the resin composition of the embodiment. This is in order to obtain a higher insulating property. The ten-point height of irregularities Rz on the surface of the copper foil can be measured using a commercially available three-dimensional profile microscope ("VK-X1000" (trade name) laser microscope by Keyence Corporation, for example).

The copper foil thickness is not particularly restricted, but from the viewpoint of roughening treatment of the surface, it is preferably in the range of 1 µm to 18 µm, and more preferably it is in the range of 2 µm to 15 µm to allow thin printed wiring boards and semiconductor element mounting boards to be more suitably obtained.

The coating method (application method) may be a method of coating a support with a solution of the resin composition of the embodiment in a solvent, for example, using a gravure coater, bar coater, die coater, doctor blade or baker applicator.

The drying conditions for removal of the solvent during fabrication of a resin sheet of the embodiment are not particularly restricted, but are preferably 1 to 90 minutes at a temperature of 20°C to 200°C, from the viewpoint of facilitating removal of the solvent in the resin composition and inhibiting progressive curing during drying. In the resin sheet of the embodiment, the resin composition may be used in the uncured state with simple drying of the solvent, or if necessary, it may be used in a semi-cured (B stage) state. In addition, the thickness of the resin layer of the resin sheet of the embodiment can be adjusted by the solution concentration and coating thickness of the resin composition of the embodiment, and while it is not particularly restricted, it is preferably 0.1 µm to 500 µm from the viewpoint of facilitating removal of the solvent during drying.

### [Prepreg]

The prepreg of the embodiment is formed from a base material and a resin composition of the embodiment. The prepreg of the embodiment can be obtained, for example, by impregnating or coating the base material with the resin composition of the embodiment, and then semi-curing it by drying at 120°C to 220°C for about 2 to 15 minutes. In this case, the degree of coverage of the resin composition on the base material, i.e., the amount of resin composition (including the filler (G)) with respect to the total amount of the semi-cured prepreg is preferably in the range of 20 mass% to 90 mass%.

The base material is not particularly restricted as long as it is a base material used for various types of printed wiring board materials. The base material may be composed of glass fibers (such as E-glass, D-glass, L-glass, S-glass, T-glass, Q-glass, UN-glass, NE-glass or spherical glass), inorganic fibers other than glass (such as quartz), or organic fibers (such as polyimide, polyamide, polyester, liquid crystal polyester or polytetrafluoroethylene). The form of the base material is not particularly restricted, and may be a woven fabric, nonwoven fabric, roving, chopped strand mat or surfacing mat. These base materials may be used alone or in combinations of two or more. Of the base materials mentioned above, woven fabrics subjected to super-opening treatment or filling treatment are preferred from the viewpoint of dimensional stability, while glass woven fabrics that have been surface-treated with a silane coupling agent by epoxysilane treatment or aminosilane treatment are preferred from the viewpoint of moisture absorbing heat resistance.

The prepreg can be obtained, for example, by impregnating or coating the base material with the resin composition, and then semi-curing it (B-staging) by drying at 120°C to 220°C for about 2 to 15 minutes. In this case, the degree of coverage of the resin composition (including the cured resin composition) on the base material, i.e., the amount of the resin composition (including the filler (G)) with respect to the total amount of the semi-cured prepreg, is preferably in the range of 20 mass% to 99 mass%. The thickness and mass of the base material are not particularly restricted, but usually a thickness of about 0.01 mm to 0.3 mm is suitable for use. From the viewpoint of strength and water absorption, a woven fabric having a base material with a thickness of 200 µm or smaller and a mass of 250 g/m² or lower is preferred.

### [Laminated sheet]

The laminated sheet is obtained by heating and pressing a laminated body including one or more prepregs, and curing the prepregs. The laminated sheet molding method and molding conditions are not particularly restricted, and common methods and conditions may be employed. For example, a multi-stage press machine, a multi-stage vacuum press machine, a continuous molding machine or an autoclave molding machine may be used for molding. For molding (laminated molding), usually the temperature is 100°C to 300°C, the pressure is 2 kgf/cm² to 100 kgf/cm² as the contact pressure, and the heating time is 0.05 hours to 5 hours. If necessary, postcuring may also be carried out at a temperature of 150°C to 300°C. In particular, when a multi-stage press machine is used, a temperature of 200°C to 250°C, a pressure of 10 kgf/cm² to 40 kgf/cm² and a heating time of 80 to 130 minutes are preferred, and a temperature of 215°C to 235°C, a pressure of 25 kgf/cm² to 35 kgf/cm² and a heating time of 90 to 120 minutes are more preferred, from the viewpoint of promoting thorough curing of the prepreg.

### [Printed wiring board]

The printed wiring board of the embodiment includes an insulating layer and a conductive layer disposed on the surface of the insulating layer, wherein the insulating layer includes a layer formed from a resin composition of the embodiment. The resin sheet of the embodiment can be used in a printed wiring board. Here, the printed wiring board can be obtained by using a resin sheet of the embodiment as a build-up material on a metal foil-clad laminated sheet with a fully-cured insulating resin layer, referred to as the "core base material," such as an insulating resin layer (resin composition layer)-attached copper foil.

The surface of the metal foil-clad laminated sheet has a conductor circuit formed of a conductive layer obtained by plating or the like after releasing the metal foil and/or metal foil of a commonly used metal foil-clad laminated sheet. The base material of the metal foil-clad laminated sheet is not particularly restricted but will usually be a glass-epoxy substrate, metal substrate, polyester substrate, polyimide substrate, BT resin substrate or thermosetting polyphenylene ether substrate.

For the embodiment, build-up is lamination of a resin sheet of the embodiment, such as the insulating resin layer of an insulating resin layer-attached copper foil, on a metal foil and/or conductive layer on the surface of the metal foil-clad laminated sheet.

Generally, when an adhesive film or the like is used as the build-up material for lamination of an insulating resin layer (resin composition layer) on a metal foil-clad laminated sheet, the resulting printed wiring board has the insulating resin layer on one or both sides. A conductive layer is formed on the insulating resin layer, but since the surface roughness of the cured insulating resin layer is low, it is common to form irregularities by roughening treatment such as desmear treatment, and to subsequently form a conductive layer by electroless plating and/or electrolytic plating.

When a resin sheet of the embodiment being used as the build-up material, such as an insulating resin layer-attached copper foil, is laminated on a metal foil-clad laminated sheet, the resulting printed wiring board has a copper foil on one or both sides. Even without plating treatment, therefore, it is possible to directly form a circuit pattern on the copper foil, and thus to form high-density fine-pitch wiring. Even if plating treatment is carried out after etching of a copper foil during production of a printed wiring board or semiconductor element mounting board, adhesiveness between the insulating resin layer and plating layer is improved since the surface condition of the copper foil surface is transferred to the insulating resin layer.

If necessary, via holes and/or through-holes may be formed during production of the printed wiring board, to establish electrical connection between each conductive layer, as necessary. Hole formation will generally be accomplished using a mechanical drill, carbon dioxide laser, UV laser or YAG laser. After holes have been formed, roughening treatment such as desmear treatment is carried out.

Roughening treatment generally includes a swelling step, a surface roughening and smear dissolution step, and a neutralization step.

The swelling step is carried out by swelling the surface of the insulating resin layer using a swelling agent. The swelling agent is not particularly restricted as long as wettability of the surface of the insulating resin layer is improved and the insulating resin layer surface is caused to swell to a degree sufficient to promote oxidative decomposition during the subsequent surface roughening and smear dissolution steps. Examples include alkali solutions and surfactant solutions.

The surface roughening and smear dissolution steps may be carried out using an oxidizing agent. Examples of oxidizing agents include alkaline permanganate solutions, with specific preferred examples being aqueous potassium permanganate and sodium permanganate solutions. The oxidizing agent treatment, also known as wet desmearing, may be carried out with appropriate combination with publicly known roughening treatments other than wet desmearing, such as dry desmearing by plasma treatment or UV treatment, mechanical polishing with a buff, or sand blasting.

The neutralization step neutralizes the oxidizing agent of the previous step using a reducing agent. Reducing agents include amine-based reducing agents, with specific suitable examples being aqueous acid water solutions such as hydroxylamine sulfate solutions, ethylenediaminetetraacetic acid solutions and nitrilotriacetic acid solutions.

For the embodiment, after via holes and/or through-holes have been formed, or after desmear treatment inside the via holes and/or through-holes, it is preferred to carry out metal plating treatment on each conductive layer for electrical connection. Even if metal plating treatment is carried out for the embodiment, since the copper foil surface is transferred to the insulating resin layer, this improves adhesiveness between the insulating resin layer and metal plating.

The method of metal plating treatment is not particularly restricted, and any metal plating treatment method commonly employed for production of multilayer printed wiring boards may be used. The method of metal plating treatment and type of chemical solution used for plating are not particularly restricted, and any metal plating treatment method and chemical solution commonly employed for production of multilayer printed wiring boards may be used. The chemical solution used for metal plating treatment may be a commercial product.

The metal plating treatment method is not particularly restricted, and for example, it may be treatment with a degreasing solution, treatment with a soft etching solution, acid cleaning or predipping solution, treatment with a catalyst liquid, treatment with an accelerator solution, treatment with a chemical copper solution, or immersion in an acid cleaning solution or copper sulfate solution followed by current application.

When a semi-cured resin sheet such as an insulating resin layer-attached copper foil has been used for build-up, for example, the semi-cured insulating resin layer can usually be heat treated for complete curing to obtain a printed wiring board. For the embodiment, the obtained printed wiring board may also be further layered with another resin sheet, such as an insulating resin layer-attached copper foil.

The method of layering in a build-up method is not particularly restricted, but it is preferred to use a vacuum laminator. In this case, the resin sheet of the embodiment such as an insulating resin layer-attached copper foil, may be laminated via an elastic solid such as rubber. The laminating conditions are not particularly restricted as long as they are conditions commonly employed for layering of printed wiring boards, and for example, the conditions may be a temperature of 70°C to 140°C and a contact pressure in the range of 1 kgf/cm² to 11 kgf/cm² and a reduced pressure atmosphere of 20 hPa or lower. After the laminating step, the laminated adhesive film may be smoothed using a metal sheet hot press. The laminating step and smoothing step may be carried out in a continuous manner using a commercially available vacuum laminator. A thermosetting step may also be carried out either after the laminating step or after the smoothing step. Using a thermosetting step will allow the insulating resin layer to be thoroughly cured. The thermosetting conditions will differ depending on the type of components in the resin composition, but usually the curing temperature will be 170°C to 220°C and the curing time will be 15 to 200 minutes.

Either one or both sides of the copper foil of the printed wiring board of the embodiment may have a circuit pattern formed by a semi-additive process, full-additive process or subtractive process. A semi-additive process is preferred from the viewpoint of forming a fine-pitch wiring pattern.

An example of a method for forming a circuit pattern by a semi-additive process is a method of using a plating resist for selective electrolytic plating (pattern plating), followed by release of the plating resist and suitable etching of the entirety to form a wiring pattern. Formation of a circuit pattern by a semi-additive process combines electroless plating with electrolytic plating, in which case the electroless plating and electrolytic plating are both preferably followed by drying. Drying after electroless plating is not particularly restricted, and for example, it is preferably carried out at 80°C to 180°C for 10 to 120 minutes, while drying after electrolytic plating is also not particularly restricted and may be carried out at 130°C to 220°C for 10 to 120 minutes, for example. Copper plating is preferred as the plating method.

An example of a method of forming a circuit pattern by a subtractive process is a method of using an etching resist for selective removal of the conductive layer to form a wiring pattern. This may be carried out in the following manner, as a specific example. The entire copper foil surface is attached by lamination (laminated) with a dry film resist (RD-1225 (trade name) of Hitachi Chemical Co., Ltd.) at a temperature of 110 ±10°C and a pressure of 0.50 ±0.02 MPa. It is then exposed along the circuit pattern for masking. Next, the dry film resist is developed with a 1% sodium carbonate solution, and finally the dry film resist is released with an amine-based resist release. This allows formation of a circuit pattern on the copper foil.

For the embodiment, the printed wiring board may be further laminated with an insulating resin layer and/or conductive layer to obtain a multilayer printed wiring board. The inner layer of the multilayer printed wiring board may also have a circuit board. The resin sheet of the embodiment, such as the insulating resin layer-attached copper foil, thus constitutes one insulating resin layer and conductive layer of the multilayer printed wiring board.

The lamination method is not particularly restricted, but usually a method commonly used for laminated molding of printed wiring boards may be used. The lamination method may be, for example, a method using a multi-stage press, multi-stage vacuum press, laminator, vacuum laminator, or autoclave molding. The temperature during lamination is not particularly restricted and may be 100°C to 300°C, for example, the pressure is not particularly restricted and may be 0.1 kgf/cm² to 100 kgf/cm² (about 9.8 kPa to about 9.8 MPa), for example, and the heating time is not particularly restricted and may be 30 seconds to 5 hours, for example. If necessary, postcuring may be carried out in a temperature range of 150°C to 300°C, for example, to adjust the curing degree.

The insulating layer of the printed wiring board of the embodiment may be the prepreg described above. The method of laminating the prepreg of the embodiment as a build-up material may be, for example, a method of stacking any number of prepregs of the embodiment onto the metal foil and/or conductive layer on the surface of the metal foil-clad laminated sheet, further laminating a copper foil over the outer side, and heat pressing to form an integral molded article.

Since the resin composition, resin sheet and printed wiring board of this embodiment contain a maleimide compound (A) having an aromatic ring in the main backbone and exhibiting a relative permittivity of lower than 2.7 at 10 GHz when cured alone, a polyphenylene ether compound (B) with a number-average molecular weight of 1000 to 7000 represented by general formula (1), and a block copolymer with a styrene skeleton (C), it is possible to obtain excellent low permittivity, low dielectric loss tangent and flexibility, as well as a small thickness, while also reducing high frequency signal loss. Moreover, since the prepreg includes a resin composition according to this embodiment, it is possible to obtain excellent moldability, low permittivity, low dielectric loss tangent and peel strength.

The present invention will now be explained in greater detail using Examples and Comparative Examples, with the understanding that the invention is in no way limited by the Examples.

### Examples

### (Example 1)

After mixing 40 parts by mass of a maleimide compound (A) represented by general formula (6), having an aromatic ring in the main backbone and a relative permittivity of lower than 2.7 at 10 GHz when cured alone (MIR-5000, relative permittivity when cured alone: 2.6, product of Nippon Kayaku Co., Ltd.), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the solid portion was diluted to 60 mass% with methyl ethyl ketone to obtain a varnish. The composition of the resin composition is shown in Table 1.

The obtained varnish was coated onto one side of a 12 µm-thick copper foil (3EC-M2S-VLP, product of Mitsui Mining & Smelting Co., Ltd.) using a bar coater, to obtain a copper-attached resin sheet. A dryer (pressure-resistant explosion-proof steam dryer, product of Takasugi MFG. Co., Ltd.) was used for heat drying of the obtained copper-attached resin sheet at 130°C for 5 minutes, to obtain a semi-cured copper-attached resin sheet having a resin thickness of 30 µm. Two semi-cured copper-attached resin sheets were heated and laminated with the resin sides of the semi-cured copper-attached resin sheets contacting each other, after which the copper foils were released and two semi-cured copper-attached resin sheets were further heated and laminated above and below with the resin sides contacting and the copper foils were released, and this procedure was repeated 4 times to obtain a semi-cured resin sheet having a resin layer thickness of 0.3 mm. The semi-cured resin sheet with a resin layer thickness of 0.3 mm was subjected to vacuum pressing at a pressure of 25 kg/cm² and a temperature of 210°C for 150 minutes, to obtain a cured resin sheet with a resin layer thickness of 0.3 mm. The obtained cured resin sheet was used to evaluate the relative permittivity, dissipation factor, peel strength and cured homogeneity, as well as the flexibility. The results are shown in Table 2.

For measurement of the relative permittivity of the maleimide compound (A), the maleimide compound (A) was diluted to a solid content of 30 mass% with methyl ethyl ketone, and the methyl ethyl ketone-diluted maleimide compound (A) was coated onto one side of a 12 µm-thick copper foil (3EC-M2S-VLP, product of Mitsui Mining & Smelting Co., Ltd.) in the same manner as for fabrication of the copper-attached resin sheet in Example 1, after which the obtained copper-attached resin sheet was heat dried at 130°C for 5 minutes to obtain a semi-cured copper-attached resin sheet with a resin thickness of 30 µm. Two semi-cured copper-attached resin sheets were heated and laminated with the resin sides of the semi-cured copper-attached resin sheets contacting each other, after which the copper foils were released and two semi-cured copper-attached resin sheets were further heated and laminated above and below with the resin sides contacting and the copper foils were released, and this procedure was repeated 4 times to obtain a semi-cured resin sheet having a resin layer thickness of 0.3 mm. The semi-cured resin sheet with a resin layer thickness of 0.3 mm was subjected to vacuum pressing at a pressure of 25 kg/cm² and a temperature of 210°C for 150 minutes, to fabricate a cured resin sheet with a resin layer thickness of 0.3 mm, and the resulting cured resin sheet was used for measurement of the relative permittivity.

### (Example 2)

After mixing 25 parts by mass of a maleimide compound (A) represented by general formula (6), having an aromatic ring in the main backbone and a relative permittivity of lower than 2.7 at 10 GHz when cured alone (MIR-5000, relative permittivity when cured alone: 2.6, product of Nippon Kayaku Co., Ltd.), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%) and 15 parts by mass of 1,3-phenylenebis(2,6-di-xylenyl phosphate) (PX-200, product of Daihachi Chemical Industry Co., Ltd.) as a phosphorus-based flame retardant (E), the solid portion was diluted to 60 mass% with methyl ethyl ketone to obtain a varnish. The composition of the resin composition is shown in Table 1. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Example 3)

After mixing 15 parts by mass of a maleimide compound (A) represented by general formula (6), having an aromatic ring in the main backbone and a relative permittivity of lower than 2.7 at 10 GHz when cured alone (MIR-5000, relative permittivity when cured alone: 2.6, product of Nippon Kayaku Co., Ltd.), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E) and 30 parts by mass of a biphenyl-type maleimide compound (D) (MIR-3000, relative permittivity when cured alone: 2.7, product of Nippon Kayaku Co., Ltd.) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4, the solid portion was diluted to 60 mass% with methyl ethyl ketone to obtain a varnish. The composition of the resin composition is shown in Table 1. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Example 4)

After mixing 40 parts by mass of a maleimide compound (A) represented by general formula (27) having an aromatic ring in the main backbone and a relative permittivity of lower than 2.7 at 10 GHz when cured alone (X9-450, relative permittivity when cured alone: 2.4, product of DIC Corporation), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the solid portion was diluted to 60 mass% with methyl ethyl ketone to obtain a varnish. The composition of the resin composition is shown in Table 3. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Example 5)

After mixing 25 parts by mass of a maleimide compound (A) represented by general formula (27), having an aromatic ring in the main backbone and a relative permittivity of lower than 2.7 at 10 GHz when cured alone (X9-450, relative permittivity when cured alone: 2.4, product of DIC Corporation), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%) and 15 parts by mass of 1,3-phenylenebis(2,6-di-xylenyl phosphate) (PX-200, product of Daihachi Chemical Industry Co., Ltd.) as a phosphorus-based flame retardant (E), the solid portion was diluted to 60 mass% with methyl ethyl ketone to obtain a varnish. The composition of the resin composition is shown in Table 3. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Example 6)

After mixing 15 parts by mass of a maleimide compound (A) represented by general formula (27), having an aromatic ring in the main backbone and a relative permittivity of lower than 2.7 at 10 GHz when cured alone (X9-450, relative permittivity when cured alone: 2.4, product of DIC Corporation), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E) and 30 parts by mass of a biphenyl-type maleimide compound (D) (MIR-3000, product of Nippon Kayaku Co., Ltd., relative permittivity when cured alone: 2.7) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4, the solid portion was diluted to 60 mass% with methyl ethyl ketone to obtain a varnish. The composition of the resin composition is shown in Table 3. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Example 7)

After mixing 15 parts by mass of a maleimide compound (A) represented by general formula (27), having an aromatic ring in the main backbone and a relative permittivity of lower than 2.7 at 10 GHz when cured alone (X9-450, relative permittivity when cured alone: 2.4, product of DIC Corporation), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E), 29 parts by mass of a biphenyl-type maleimide compound (D) (MIR-3000, product of Nippon Kayaku Co., Ltd., relative permittivity when cured alone: 2.7) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4 and 1 part by mass of a cyanic acid ester compound (SNCN) (F) obtained by Synthesis Example 1 below, the solid portion was diluted to 60 mass% with methyl ethyl ketone to obtain a varnish. The composition of the resin composition is shown in Table 3. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Synthesis Example 1) Synthesis of cyanic acid ester compound

After dissolving 300 g of a 1-naphtholaralkyl resin (product of Nippon Steel & Sumitomo Metal Corporation) (1.28 mol as OH groups) and 194.6 g (1.92 mol) of triethylamine (1.5 mol with respect to 1 mol of hydroxyl groups) in 1800 g of dichloromethane, the resulting solution was used as solution 1.

While stirring 125.9 g (2.05 mol) of cyanogen chloride (1.6 mol with respect to 1 mol of hydroxyl groups), 293.8 g of dichloromethane, 194.5 g (1.92 mol) of 36% hydrochloric acid (1.5 mol with respect to 1 mol of hydroxyl groups) and 1205.9 g of water, the mixture was kept at a liquid temperature of -2°C to -0.5°C while adding solution 1 dropwise over a period of 30 minutes. Upon completion of dropwise addition of solution 1 and stirring at the same temperature for 30 minutes, a solution of 65 g (0.64 mol) of triethylamine (0.5 mol with respect to 1 mol of hydroxyl groups) dissolved in 65 g of dichloromethane (solution 2) was added dropwise over a period of 10 minutes. After the dropwise addition of solution 2, the mixture was stirred at the same temperature for 30 minutes to complete the reaction.

The reaction mixture was then allowed to stand for separation of the organic phase and aqueous phase. The obtained organic phase was washed 5 times with 1300 g of water. The electric conductivity of the waste water after the 5th washing was 5 µS/cm, and it was confirmed that washing with water could sufficiently remove the ionic compound to be removed.

The washed organic phase was concentrated under reduced pressure, and finally concentrated and dried for 1 hour at 90°C to obtain 331 g of the target naphtholaralkyl-type cyanic acid ester compound (SNCN) (orange viscous substance). The weight-average molecular weight Mw of the obtained SNCN was 600. The IR spectrum of the SNCN showed absorption at 2250 cm⁻¹ (cyanic acid ester groups), and no absorption of hydroxyl groups.

### (Example 8)

After mixing 15 parts by mass of a maleimide compound (A) represented by general formula (27), having an aromatic ring in the main backbone and a relative permittivity of lower than 2.7 at 10 GHz when cured alone (X9-470, relative permittivity when cured alone: 2.4, product of DIC Corporation), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E), 29 parts by mass of a biphenyl-type maleimide compound (D) (MIR-3000, product of Nippon Kayaku Co., Ltd., relative permittivity when cured alone: 2.7) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4 and 1 part by mass of SNCN (F) obtained by Synthesis Example 1 in Example 7, the solid portion was diluted to 60 mass% with methyl ethyl ketone to obtain a varnish. The composition of the resin composition is shown in Table 3. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Example 9)

After mixing 40 parts by mass of a maleimide compound (A) represented by general formula (27) having an aromatic ring in the main backbone and a relative permittivity of lower than 2.7 at 10 GHz when cured alone (X9-470, relative permittivity when cured alone: 2.4, product of DIC Corporation), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the solid portion was diluted to 60 mass% with methyl ethyl ketone to obtain a varnish. The composition of the resin composition is shown in Table 3. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Comparative Example 1)

After mixing 40 parts by mass of a biphenyl-type maleimide compound (D) represented by general formula (3), wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4 (MIR-3000, relative permittivity when cured alone: 2.7, product of Nippon Kayaku Co., Ltd.), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), and 25 parts by mass of a styrene-butadiene block copolymer (C) (TR2250, product of JSR Corporation, styrene ratio: 52%), the solid portion was diluted to 60 mass% with methyl ethyl ketone to obtain a varnish. The composition of the resin composition is shown in Table 1. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Comparative Example 2)

After mixing 50 parts by mass of a maleimide compound (A) having an aromatic ring in the main backbone and a relative permittivity of lower than 2.7 at 10 GHz when cured alone (MIR-5000, relative permittivity when cured alone: 2.6, product of Nippon Kayaku Co., Ltd.) and 50 parts by mass of a styrene-butadiene block copolymer (C) (TR2250, product of JSR Corporation, styrene ratio: 52%), the solid portion was diluted to 60 mass% with methyl ethyl ketone to obtain a varnish. The composition of the resin composition is shown in Table 1. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Comparative Example 3)

After mixing 50 parts by mass of a maleimide compound (A) having an aromatic ring in the main backbone and a relative permittivity of lower than 2.7 at 10 GHz when cured alone (MIR-5000, relative permittivity when cured alone: 2.6, product of Nippon Kayaku Co., Ltd.) and 50 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), the solid portion was diluted to 60 mass% with methyl ethyl ketone to obtain a varnish. The composition of the resin composition is shown in Table 1. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Comparative Example 4)

After mixing 50 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 50 parts by mass of a styrene-butadiene block copolymer (C) (TR2250, product of JSR Corporation, styrene ratio: 52%), the solid portion was diluted to 60 mass% with methyl ethyl ketone to obtain a varnish. The composition of the resin composition is shown in Table 1. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

### (Comparative Example 5)

After mixing 40 parts by mass of a maleimide compound (D) represented by general formula (16) (BMI-70, relative permittivity when cured alone: 3.2, product of K.I Chemical Industry Co., Ltd.), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the solid portion was diluted to 60 mass% with methyl ethyl ketone to obtain a varnish. The composition of the resin composition is shown in Table 1. A cured resin sheet with a resin layer thickness of 0.3 mm was otherwise fabricated in the same manner as Example 1, and the relative permittivity, dissipation factor, peel strength, cured homogeneity and flexibility were evaluated. The evaluation results for the obtained cured resin sheet are shown in Table 2.

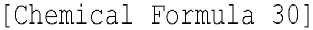

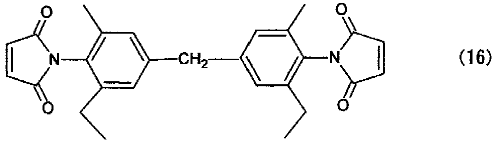

The maleimide compound (D) represented by general formula (16) is a compound of general formula (4) where R₆₁ and R₆₃ are methyl groups, R₆₂ and R₆₄ are ethyl groups and R₇₁ and R₇₂ are hydrogen atoms.

**[Table 1]**

| Composition (parts by mass) | Example 1 | Example 2 | Example 3 | Comp. Ex. 1 | Comp. Ex. 2 | Comp. Ex. 3 | Comp. Ex. 4 | Comp. Ex. 5 |
|---|---|---|---|---|---|---|---|---|
| Maleimide compound (A) | 40 | 25 | 15 | - | 50 | 50 | - | - |
| Polyphenylene ether compound (B) | 35 | 35 | 15 | 35 | - | 50 | 50 | 35 |
| Styrene skeleton-containing block copolymer (C) | 25 | 25 | 25 | 25 | 50 | - | 50 | 25 |
| Maleimide compound (D) | - | - | 30 | 40 | - | - | - | 40 |
| Flame retardant (E) | - | 15 | 15 | - | - | - | - | - |

**[Table 2]**

| | | Example | | | | | | | | | Comparative Example | | | | |
|---|---|---|---|---|---|---|---|---|---|---|---|---|---|---|---|
| | | 1 | 2 | 3 | 4 | 5 | 6 | 7 | 8 | 9 | 1 | 2 | 3 | 4 | 5 |
| Relative permittivity | | 2.5 | 2.6 | 2.6 | 2.4 | 2.5 | 2.6 | 2.6 | 2.6 | 2.4 | 2.7 | 2.3 | 2.5 | 2.4 | 2.9 |
| Dissipation factor | | 0.0019 | 0.0018 | 0.0021 | 0.0019 | 0.0018 | 0.0021 | 0.0022 | 0.0021 | 0.0019 | 0.0026 | 0.0021 | 0.0021 | 0.0022 | 0.0030 |
| Peel strength | kN/m | 0.5 | 0.5 | 0.7 | 0.5 | 0.5 | 0.7 | 0.7 | 0.7 | 0.5 | 0.6 | 0.4 | 0.3 | 0.3 | 0.7 |
| Cured homogeneity | | OK | OK | OK | OK | OK | OK | OK | OK | OK | OK | NG | OK | OK | OK |
| Flexibility evaluation | | 8 | 8 | 8 | 8 | 8 | 8 | 8 | 8 | 8 | 8 | 2 | 19 | 2 | 10 |

**[Table 3]**

| Composition (parts by weight) | Example 4 | Example 5 | Example 6 | Example 7 | Example 8 | Example 9 |
|---|---|---|---|---|---|---|
| Maleimide compound (A) | 40 | 25 | 15 | 15 | 15 | 40 |
| Polyphenylene ether compound (B) | 35 | 35 | 15 | 15 | 15 | 35 |
| Styrene skeleton-containing block copolymer (C) | 25 | 25 | 25 | 25 | 25 | 25 |
| Maleimide compound (D) | - | - | 30 | 29 | 29 | - |
| Flame retardant (E) | - | 15 | 15 | 15 | 15 | - |
| Cyanic acid ester compound (F) | - | - | - | 1 | 1 | - |

### (Measuring methods and evaluation methods for Examples 1 to 9 and Comparative Examples 1 to 5)

### (1) Relative permittivity (Dk) and dissipation factor (Df):

A sample obtained by removing the copper foil from the cured resin sheet obtained in each of the Examples or Comparative Examples was used to measure the relative permittivity and dissipation factor at 10 GHz, using a perturbation cavity resonator (CP-531, product of KANTO Electronic Application and Development Inc.).

### (2) Copper foil peel strength:

The cured resin sheet obtained in each of the Examples and Comparative Examples was measured for copper foil peel strength using a 12 µm copper foil-attached test piece (30 mm × 150 mm × 0.3 mm) according to JIS C6481, and the average lower limit for the test pieces was recorded as the measured value.

### (3) Cured homogeneity:

A cross-section of the cured resin sheet obtained in each of the Examples and Comparative Examples was polished using a MetaServ3000 by Buehler Co., and the condition of the cross-section was observed using an EPIPHOT by Nikon Corporation. Sheets with voids or diffuse defects were evaluated as NG, and those without the defects were evaluated as OK.

### (4) Evaluation of flexibility

The semi-cured copper-attached resin sheet with a resin thickness of 30 µm obtained in each of the Examples and Comparative Examples was used for a cylindrical mandrel bending test according to JIS K5600-5-1, and the diameter of the first mandrel with resin cracking was recorded.

### (Results for Examples 1 to 9 and Comparative Examples 1 to 5)

As shown in Table 2, Comparative Example 1 and Comparative Example 5, in which a maleimide compound (D) was mixed instead of maleimide compound (A), had higher relative permittivities and dissipation factors compared to the Examples. Comparative Example 2, in which a polyphenylene ether compound (B) was not mixed had poor cured homogeneity, and lower peel strength compared to the Examples. Comparative Example 3, in which a styrene-butadiene block copolymer (C) was not mixed had poorer flexibility and lower peel strength compared to the Examples. Comparative Example 4, in which a maleimide compound (A) and maleimide compound (D) were not mixed had low relative permittivity but lower peel strength compared to the Examples.

In other words, it was confirmed that using a resin composition of the invention allows excellent low permittivity, low dielectric loss tangent, peel strength and flexibility to be obtained, and can provide a homogeneous cured product.

### (Example 10)

After mixing 40 parts by mass of a maleimide compound (A) represented by general formula (6) (MIR-5000, product of Nippon Kayaku Co., Ltd.), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 4.

### (Example 11)

After mixing 25 parts by mass of a maleimide compound (A) represented by general formula (6) (MIR-5000, product of Nippon Kayaku Co., Ltd.), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%) and 15 parts by mass of 1,3-phenylenebis(2,6-di-xylenyl phosphate) (PX-200, product of Daihachi Chemical Industry Co., Ltd.) as a phosphorus-based flame retardant (E), the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 4.

### (Example 12)

After mixing 15 parts by mass of a maleimide compound (A) represented by general formula (6) (MIR-5000, product of Nippon Kayaku Co., Ltd.), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E) and 30 parts by mass of a biphenyl-type maleimide compound (D) (MIR-3000, product of Nippon Kayaku Co., Ltd.) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4, the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 4.

### (Example 13)

After mixing 40 parts by mass of a maleimide compound (A) represented by general formula (27) (X9-450, product of DIC Corporation), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 6.

### (Example 14)

After mixing 25 parts by mass of a maleimide compound (A) represented by general formula (27) (X9-450, product of DIC Corporation), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%) and 15 parts by mass of 1,3-phenylenebis(2,6-di-xylenyl phosphate) (PX-200, product of Daihachi Chemical Industry Co., Ltd.) as a phosphorus-based flame retardant (E), the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 6.

### (Example 15)

After mixing 15 parts by mass of a maleimide compound (A) represented by general formula (27) (X9-450, product of DIC Corporation), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E) and 30 parts by mass of a biphenyl-type maleimide compound (D) (MIR-3000, product of Nippon Kayaku Co., Ltd.) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4, the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 6.

### (Example 16)

After mixing 40 parts by mass of a maleimide compound (A) represented by general formula (27) (X9-470, product of DIC Corporation), 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 6.

### (Example 17)

After mixing 15 parts by mass of a maleimide compound (A) represented by general formula (27) (X9-450, product of DIC Corporation), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E), 29 parts by mass of a biphenyl-type maleimide compound (D) (MIR-3000, product of Nippon Kayaku Co., Ltd.) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4, and 1 part by mass of the cyanic acid ester compound (SNCN) (F) obtained in Synthesis Example 1 of Example 7, the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 6.

### (Example 18)

After mixing 15 parts by mass of a maleimide compound (A) represented by general formula (27) (X9-470, product of DIC Corporation), 15 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), 25 parts by mass of a styrene-butadiene block copolymer (C) (TR2250, product of JSR Corporation, styrene ratio: 52%), 15 parts by mass of 1,3-phenylenebis(2,6-di-xylenyl phosphate) (PX-200, product of Daihachi Chemical Industry Co., Ltd.) as a phosphorus-based flame retardant (E), 29 parts by mass of a biphenyl-type maleimide compound (D) (MIR-3000, product of Nippon Kayaku Co., Ltd.) of general formula (3) wherein R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ are hydrogen atoms and n₅ has an average value of 1.4, and 1 part by mass of the cyanic acid ester compound (SNCN) (F) obtained in Synthesis Example 1 of Example 8, the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 6.

### (Comparative Example 6)

After mixing 50 parts by mass of a maleimide compound (A) (MIR-5000, product of Nippon Kayaku Co., Ltd.) and 50 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.), the varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 3.

### (Comparative Example 7)

After mixing 50 parts by mass of a maleimide compound (A) (MIR-5000, product of Nippon Kayaku Co., Ltd.) and 50 parts by mass of a styrene-butadiene block copolymer (C) (TR2250, product of JSR Corporation, styrene ratio: 52%), the varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 3.

### (Comparative Example 8)

After mixing 50 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 50 parts by mass of a styrene-butadiene block copolymer (C) (TR2250, product of JSR Corporation, styrene ratio: 52%), the varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 3.

### (Comparative Example 9)

After mixing 40 parts by mass of a maleimide compound (D) represented by general formula (16) (BMI-70, product of K.I Chemical Industry Co., Ltd.) which was used in Comparative Example 5, 35 parts by mass of a polyphenylene ether compound (B) wherein, in general formula (10), X is general formula (11) and -(Y-O)n₂- is a polymerized structural unit of general formula (14) (OPE-2St2200, product of Mitsubishi Gas Chemical Company, Inc., number-average molecular weight: 2200, vinyl group equivalents: 1100 g/eq.) and 25 parts by mass of a styrene-butadiene block copolymer (C) (TR2250, product of JSR Corporation, styrene ratio: 52%), the mixture was dissolved in methyl ethyl ketone to obtain a varnish. The varnish was dip coated onto an E-glass fiber base material and heat dried at 165°C for 3 minutes to obtain a prepreg with a resin composition content of 68 vol% and a thickness of about 0.1 mm. The composition of the resin composition is shown in Table 3.

### (Fabrication of evaluation samples for Examples 10 to 18 and Comparative Examples 6 to 9)

Eight of the prepregs obtained in Examples 10 to 18 and Comparative Examples 6 to 9 were stacked, for each of the Examples and Comparative Examples, copper foil (3EC-M3-VLP, product of Mitsui Mining & Smelting Co., Ltd., 12 µm thickness) was set on both the upper and lower sides, and laminated molding (thermosetting) was carried out for 100 minutes at a pressure of 5 kgf/cm² and a temperature of 230°C, to obtain copper foil-clad laminated sheets each with an insulating layer thickness of about 0.8 mm.

### (Evaluation of moldability for Examples 10 to 18 and Comparative Examples 6 to 9)

The copper foil-clad laminated sheets obtained in each of the Examples and Comparative Examples were removed by etching, and those with visible voids and diffuse defects in the surface or cross-section were evaluated as NG while those without the defects were evaluated as OK. The results are shown in Table 5. Here, "voids" means gaps formed by an absence of glass fibers and cured resin.

### (Evaluation of relative permittivity and dissipation factor for Examples 10 to 18 and Comparative Examples 6 to 9)

The copper foil-clad laminated sheets obtained in each of the Examples and Comparative Examples were cut to a size of 100 mm × 1.0 mm with a dicing saw, and then the surface copper foil was removed by etching to obtain a measuring sample. The sample was used for measurement of the relative permittivity and dissipation factor at 10 GHz using a perturbation method cavity resonator (CP-531, product of KANTO Electronic Application and Development Inc.). The measurement results are shown in Table 5.

### (Evaluation of peel strength for Examples 10 to 18 and Comparative Examples 6 to 9)

The copper foil-clad laminated sheets obtained in each of the Examples and Comparative Examples were cut to a size of 150 mm × 30 mm with a dicing saw, and then three test pieces were measured for copper foil peel strength according to JIS C6481, and the average lower limit for the test pieces was recorded as the measured value. The results are shown in Table 5.

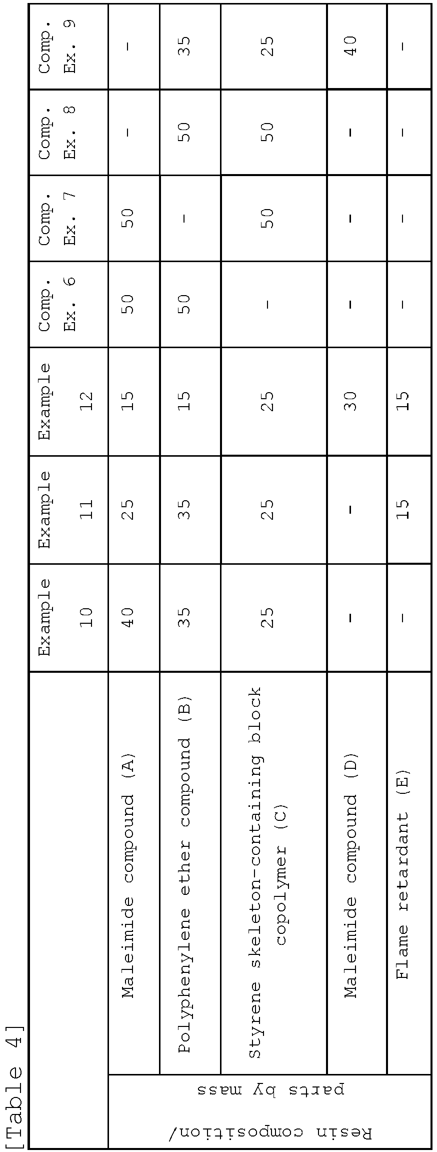

**[Table 5]**

| | | Example | | | | | | | | | Comparative Example | | | |
|---|---|---|---|---|---|---|---|---|---|---|---|---|---|---|
| | | 10 | 11 | 12 | 13 | 14 | 15 | 16 | 17 | 18 | 6 | 7 | 8 | 9 |
| Moldability | | OK | OK | OK | OK | OK | OK | OK | OK | OK | OK | NG | NG | OK |
| Relative permittivity | | 3.5 | 3.5 | 3.5 | 3.4 | 3.4 | 3.5 | 3.4 | 3.5 | 3.5 | 3.7 | Not measured | Not measured | 3.7 |
| Dissipation factor | | 0.0038 | 0.0042 | 0.0040 | 0.0037 | 0.0043 | 0.0040 | 0.0036 | 0.0041 | 0.0041 | 0.0045 | Not measured | Not measured | 0.0050 |
| Peel strength | kN/m | 0.6 | 0.6 | 0.6 | 0.6 | 0.6 | 0.6 | 0.6 | 0.6 | 0.6 | 0.3 | Not measured | Not measured | 0.6 |

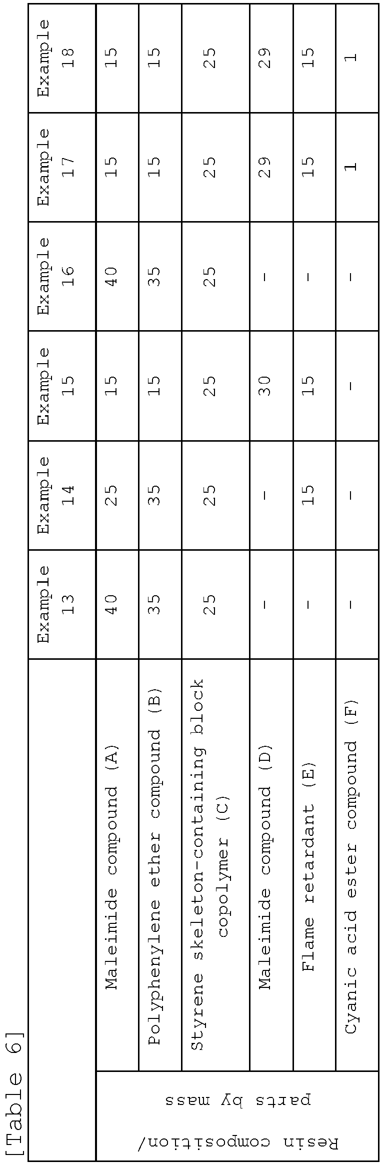

As shown in Tables 4 to 6, it was confirmed that the prepregs containing a maleimide compound (A) having an aromatic group in the main backbone, a polyphenylene ether compound (B) and a block copolymer with a styrene skeleton (C), or a maleimide compound (A), a polyphenylene ether compound (B), a block copolymer with a styrene skeleton (C) and a maleimide compound (D) in the resin compositions impregnated or coated onto the glass fiber base materials, as described in Examples 10 to 18, exhibited no defective molding of the lamination materials obtained by thermosetting, and had relative permittivities of 3.5 or lower, dissipation factors of 0.0043 or lower and peel strengths of 0.6 kN/m.

In contrast, it was also confirmed that, with the prepregs containing a maleimide compound (A) having an aromatic group in the main backbone and a polyphenylene ether compound (B) in the resin compositions impregnated or coated onto glass fiber base materials as described in Comparative Example 6, the relative permittivities and dissipation factors of the lamination materials obtained by thermosetting were higher compared to the Examples, while the peel strengths were lower compared to the Examples.

It was further confirmed that, with the prepregs containing a maleimide compound (A) having an aromatic group in the main backbone and a block copolymer with a styrene skeleton (C) in the resin compositions impregnated or coated onto glass fiber base materials as described in Comparative Example 7, molding defects were generated in the lamination materials obtained by thermosetting, and the relative permittivities and dissipation factors and peel strengths were unmeasurable.

It was further confirmed that, with the prepregs containing a polyphenylene ether compound (B) having an aromatic group in the main backbone and a block copolymer with a styrene skeleton (C) in the resin compositions impregnated or coated onto glass fiber base materials as described in Comparative Example 8, molding defects were generated in the lamination materials obtained by thermosetting, and the relative permittivities and dissipation factors and peel strengths were unmeasurable.

It was still further confirmed that, with the prepregs containing a maleimide compound (D) having an aromatic group in the main backbone, a polyphenylene ether compound (B) and a block copolymer with a styrene skeleton (C) in the resin compositions impregnated or coated onto glass fiber base materials as described in Comparative Example 9, the relative permittivities and dissipation factors of the lamination materials obtained by thermosetting were higher compared to the Examples.

In other words, it was confirmed that the Examples were able to provide excellent moldability, low permittivity, low dielectric loss tangent and peel strength.

### Industrial Applicability

As explained above, the resin composition of the invention is widely and effectively applicable for various uses including electrical and electronic materials, machine tool materials and aviation materials, as electrical insulating materials, semiconductor plastic packages, sealing materials, adhesives, laminating materials, resists and build-up laminated sheet materials, etc., and it is especially effective for use in printed wiring board materials suitable for high integration and high densification, to be used in recent data terminal devices, communication devices, and the like.

## Claims

1. A resin composition containing (A) a maleimide compound having an aromatic ring in the main backbone and exhibiting a relative permittivity of lower than 2.7 at 10 GHz when cured alone, (B) a polyphenylene ether compound represented by general formula (1) below and having a number-average molecular weight of 1000 to 7000, and (C) a block copolymer with a styrene skeleton. 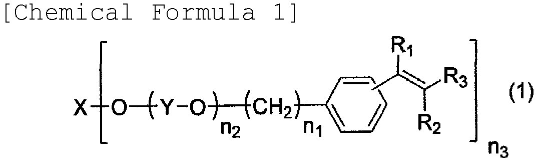 (In general formula (1), X represents an aryl group, -(Y-O)n₂- represents a polyphenylene ether portion, R₁, R₂ and R₃ each independently represent a hydrogen atom or an alkyl, alkenyl or alkynyl group, n₂ represents an integer of 1 to 100, n₁ represents an integer of 1 to 6 and n₃ represents an integer of 1 to 4.)

2. The resin composition according to claim 1, wherein the maleimide compound (A) is at least one selected from the group consisting of compounds represented by general formula (6) and compounds represented by general formula (22). 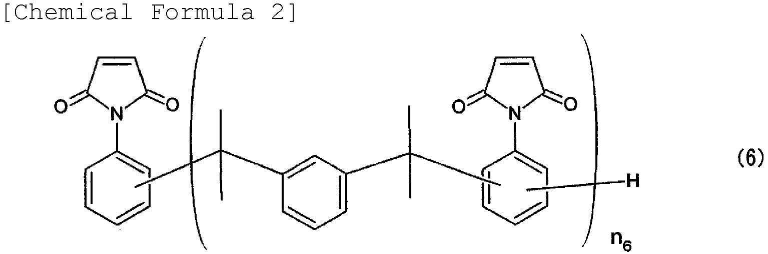 (In general formula (6), n₆ represents an integer of 1 or greater.) 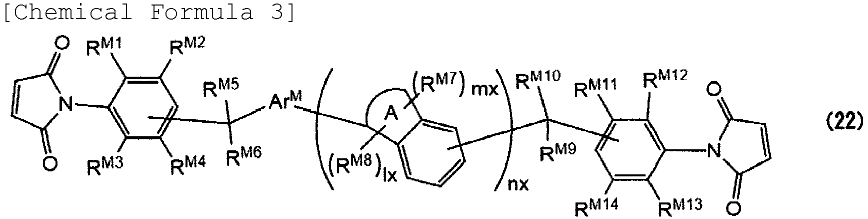 (In general formula (22), R^{M1}, R^{M2}, R^{M3} and R^{M4} each independently represent a hydrogen atom or an organic group. R^{M5} and R^{M6} each independently represent a hydrogen atom or an alkyl group. Ar^{M} represents a divalent aromatic group. A is an alicyclic group with a 4- to 6-membered ring. R^{M7} and R^{M8} each independently represent an alkyl group. mₓ is 1 or 2 and lₓ is 0 or 1. R^{M9} and R^{M10} each independently represent a hydrogen atom or an alkyl group. R^{M11}, R^{M12}, R^{M13} and R^{M14} each independently represent a hydrogen atom or an organic group. nₓ represents an integer of 0 to 20.)

3. The resin composition according to claim 1, wherein the block copolymer with a styrene skeleton (C) contains at least one selected from the group consisting of styrene-butadiene block copolymers, styrene-isoprene block copolymers, styrene-hydrogenated butadiene block copolymers, styrene-hydrogenated isoprene copolymers and styrene-hydrogenated (isoprene/butadiene) copolymers.

4. The resin composition according to claim 1, which further contains a maleimide compound (D) other than the maleimide compound (A).

5. The resin composition according to claim 4, wherein the maleimide compound (D) contains at least one selected from the group consisting of the following general formulas (2), (3), (4) and (5). 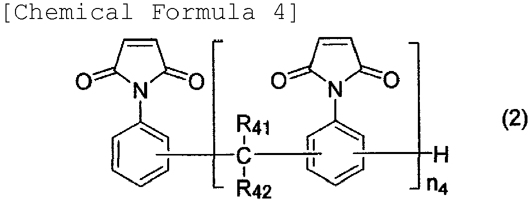 (In general formula (2), R₄₁ and R₄₂ each independently represent a hydrogen atom or methyl group, and n₄ represents an integer of 1 or greater.) 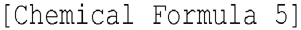 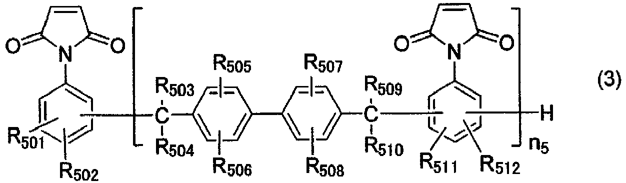 (In general formula (3), R_{501,} R₅₀₂, R₅₀₃, R₅₀₄, R₅₀₅, R₅₀₆, R₅₀₇, R₅₀₈, R₅₀₉, R₅₁₀, R₅₁₁ and R₅₁₂ each independently represent a hydrogen atom or an alkyl group of 1 to 8 carbon atoms or a phenyl group, and n₅ represents an integer of 1 to 10.) 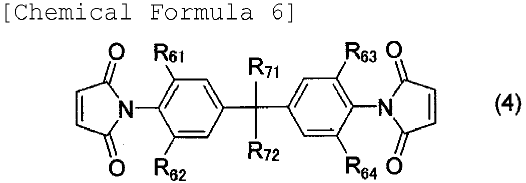 (In general formula (4), R₆₁, R₆₂, R₆₃ and R₆₄ each independently represent a hydrogen atom or a methyl or ethyl group, and R₇₁ and R₇₂ each independently a hydrogen atom or a methyl group.) 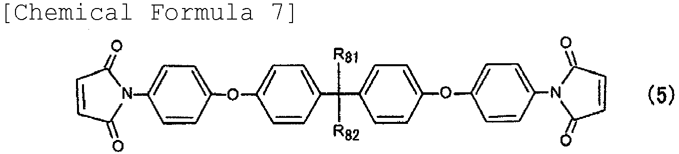 (In general formula (5), R₈₁ and R₈₂ each independently represent a hydrogen atom or a methyl or ethyl group.)

6. The resin composition according to claim 1, which further contains a flame retardant (E).

7. The resin composition according to claim 1, which further contains a cyanic acid ester compound (F).

8. A resin sheet including a support and a layer formed from a resin composition according to claim 1 disposed on the surface of the support.

9. A prepreg including a base material and a resin composition according to claim 1 impregnated into or coated onto the base material.

10. A printed wiring board including an insulating layer and a conductive layer disposed on the surface of the insulating layer, wherein the insulating layer includes a layer formed from a resin composition according to claim 1.
